# EUROPEAN PATENT SPECIFICATION

(11) **EP 1 060 141 B1**
(45) Date of publication and mention of the grant of the patent: **30.10.2002**
(21) Application number: 99908438.7
(22) Date of filing: 25.02.1999
(51) Int. Cl.: C03C 25/10, C08J 5/08, H05K 1/03

(54) **IMPREGNATED GLASS FIBER STRANDS AND PRODUCTS INCLUDING THE SAME**
IMPRÄGNIERTE GLASSPINNFÄDEN UND DIESE ENTHALTENDE PRODUKTE
BRINS DE FIBRES DE VERRE IMPREGNEES ET PRODUITS COMPORTANT DE TELS BRINS

(30) Priority: 03.03.1998 US 34077; 13.10.1998 US 170566
(43) Date of publication of application: 20.12.2000
(73) Proprietor: PPG Industries Ohio, Inc., Cleveland, OH 44111 (US)
(72) Inventor: NOVICH, Bruce E., Barrington, Rhode Island 02806 (US); ROBERTSON, Walter, J., Pittsburgh, PA 15202 (US)
(74) Representative: Sternagel, Fleischer, Godemeyer & Partner Patentanwälte
(86) International application number: US9904056
(87) International publication number: WO99044955

(56) References cited:
- WO-A-90/01860
- WO-A-96/39364
- US-A- 3 312 569
- US-A- 5 217 778
- DATABASE WPI Section Ch, Week 9706 Derwent Publications Ltd., London, GB; Class A85, AN 97-060830 XP002106571 & JP 08 309928 A (HITACHI CHEM CO LTD) , 26 November 1996
- DATABASE WPI Section Ch, Week 9728 Derwent Publications Ltd., London, GB; Class A18, AN 97-306602 XP002106572 & JP 09 118759 A (MATSUSHITA ELECTRIC WORKS LTD), 6 May 1997
- PATENT ABSTRACTS OF JAPAN vol. 014, no. 423 (C-0757), 12 September 1990 & JP 02 160944 A (NITTO BOSEKI CO LTD), 20 June 1990
- DATABASE INSPEC INSTITUTE OF ELECTRICAL ENGINEERS, STEVENAGE, GB Inspec No. 6242125, NOVICH B E: "Hybon RCY yarns: a laminate reinforcement developed for printed circuit boards" XP002106570 & CIRCUITREE, MARCH 1999, CIRCUITREE, USA, vol. 12, no. 3, page 44, 46, 51 ISSN 1059-843X

## Description

### Field of the Invention

This invention relates generally to coated glass fiber strands for reinforcing composites and, more specifically, to glass fiber strands impregnated with solid particles which provide interstitial spaces between adjacent glass fibers of the strand, the solid particles having a minimum average particle size of at least 3 micrometers.

### Background of the Invention

In thermosetting molding operations, good "wet-through" (penetration of the polymeric matrix material through the mat) and "wet-out" (penetration of the polymeric matrix material through the individual bundles or strands of fibers in the mat) properties are desirable. In contrast, good dispersion properties are of predominant concern in typical thermoplastic molding operations.

For improving resin impregnation, Japanese Patent Application No. 9-208,268 discloses a cloth having yarn formed from glass fibers coated immediately after spinning with starch or a synthetic resin and 0.001 - 20.0 weight percent of inorganic solid particles such as colloidal silica, calcium carbonate, kaolin and talc having average particles sizes of 5 to 2000 nanometers (0.05 to 2 micrometers). in paragraph 13 of the Detailed Description of the Invention, it is disclosed that such coatings having more than 20 weight percent inorganic solid particles cannot be applied to the glass fiber.

To improve penetration of resin between glass reinforcement fibers during formation of a composite, U.S. Patent No. 3,312,569 discloses adhering particles of alumina to the surfaces of the glass fibers. However the Mohs' hardness values of alumina is greater than about 9¹, which can cause abrasion of softer glass fibers.
¹ See R. Weast (Ed.), Handbook of Chemistry and Physics, CRC Press (1975) at page F-22, which is hereby incorporated by reference.

Soviet Union No. 859400 discloses an impregnating composition for manufacturing laminates of glass fiber cloth, the composition containing an alcoholic solution of phenol-formaldehyde resin, graphite, molybdenum disulphide, polyvinyl butyral and surfactant. Volatile alcoholic solvents are not desirable for glass fiber production applications.

To enhance, reduce or modify frictional characteristics of a composite, U.S. Patent No. 5,217,778 discloses a dry clutch facing including a composite yarn of glass fibers, metallic wire and polyacrylonitrile fibers which are impregnated and coated with a heat curable cement or binder system. The binder can include friction particles such as carbon black, graphite, metal oxides, barium sulfate, aluminum silicate, ground rubber particles, ground organic resins, polymerized cashew nut oil, clay, silica or cryolite (see col. 2, lines 55-66).

There is a need for coatings for inhibiting abrasion and breakage of glass fibers which are compatible with a wide variety of polymeric matrix materials.

### Summary of the Invention

The present invention provides a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers.

Another aspect of the present invention is a coated fiber strand comprising a plurality of glass fibers having an average nominal fiber diameter greater than 5 micrometers, the strand being at least partially impregnated with (1) a primary layer of a dried residue of a sizing composition applied to at least a portion of surfaces of the plurality of glass fibers and (2) a secondary layer of an aqueous secondary coating composition applied over at least a portion of the primary layer, the secondary coating composition comprising solid particles which provide interstitial spaces between adjacent glass fibers of the strand, the solid particles having a minimum average particle size of at least 3 5 micrometers.

Yet another aspect of the present invention is a coated fiber strand comprising a plurality of glass fibers having an average nominal fiber diameter greater than 5 micrometers, the strand being at least partially impregnated with (1) a primary layer of a dried residue of a sizing composition applied to at least a portion of surfaces of the plurality of glass fibers and (2) a secondary layer of a dried residue of an aqueous secondary coating composition applied over at least a portion of the primary layer, the secondary coating composition comprising hydrophilic solid particles which provide interstitial spaces between adjacent glass fibers of the strand, the hydrophilic solid particles having a minimum average particle size of at least 3 micrometers and which upon exposure to water absorb and retain water in interstices within the hydrophilic solid particles.

Another aspect of the present invention is a coated fiber strand comprising a plurality of glass fibers having an average nominal fiber diameter greater than 5 micrometers, the strand being at least partially impregnated with (1) a primary layer of a dried residue of a sizing composition applied to at least a portion of surfaces of the plurality of glass fibers; (2) a secondary layer of a secondary coating composition applied over at least a portion of the primary layer, the secondary coating composition comprising a polymeric material; and a tertiary layer comprising powdered solid particles applied over at least a portion of the secondary layer which provide interstitial spaces between adjacent glass fibers of the strand, the solid particles having a minimum average particle size of at least 3 micrometers.

Yet another aspect of the present invention is a reinforced polymeric composite comprising: (a) a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers; and (b) a polymeric matrix material.

Another aspect of the present invention is a fabric comprising a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers.

Yet another aspect of the present invention is an electronic support comprising: (a) a fabric comprising a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers; and (b) a layer of a polymeric matrix material applied over at least a portion of the fabric.

Another aspect of the present invention is an electronic circuit board comprising: (a) an electronic support comprising: (i) a fabric comprising a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers; and (ii) a layer of a polymeric matrix material applied over at least a portion of the fabric; and (b) an electrically conductive layer positioned adjacent to selected portions of selected sides of the electronic support.

Still another aspect of the present invention is an electronic support comprising: (a) a first composite layer comprising: (i) a fabric comprising a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers; and (ii) a layer of a polymeric matrix material applied over at least a portion of the fabric; and (b) a second composite layer different from the first composite layer.

Yet another aspect of the present invention is an electronic circuit board comprising: (a) an electronic support comprising: (i) a first composite layer comprising: (1) a fabric comprising a coated fiber strand comprising a plurality of glass fibers having an average nominal fiber diameter greater than 5 micrometers, the strand being at least partially impregnated with a dried residue of an aqueous sizing composition comprising solid particles which provide interstitial spaces between adjacent glass fibers of the strand, the solid particles having a minimum average particle size of at least 3 micrometers and a hardness which does not exceed a hardness of the plurality of glass fibers; and (2) a layer of a polymeric matrix material applied over at least a portion of the fabric; and (ii) a second composite layer different from the first composite layer; and (b) an electrically conductive layer positioned adjacent to selected portions of selected sides of the first and/or second composite layers.

### Brief Description of the Drawings

The foregoing summary, as well as the following detailed description of the preferred embodiments, will be better understood when read in conjunction with the appended drawings. In the drawings:
Fig. 1 is a perspective view of a coated fiber strand having a primary layer of a dried residue of an aqueous sizing composition according to the present invention;
Fig. 2 is a perspective view of a coated fiber strand having a primary layer of a dried residue of a sizing composition and thereupon a secondary layer of an aqueous secondary coating composition according to the present invention;
Fig. 3 is a perspective view of a coated fiber strand having a primary layer of a dried residue of a sizing composition, a secondary layer of an aqueous secondary coating composition, and a tertiary layer thereupon according to the present invention;
Fig. 4 is a top plan view of a composite according to the present invention;
Fig. 5 is a top plan view of a fabric according to the present invention;
Fig. 6 is a cross-sectional view of an electronic support according to the present invention; and
Figs. 7 and 8 are cross-sectional views of alternate embodiments of an electronic support according to the present invention.

### Detailed Description of the Invention

The glass fiber strands of the present invention have a unique coating which not only inhibits abrasion and breakage of the fibers during processing but can provide good wet-through, wet-out and dispersion properties in formation of composites. Good laminate strength, good thermal stability, good hydrolytic stability, low corrosion and reactivity in the presence of high humidity, reactive acids and alkalies and compatibility with a variety of polymeric matrix materials, which can eliminate the need for heat cleaning prior to lamination, are other desirable characteristics which can be exhibited by the coated glass fiber strands of the present invention.

Another significant advantage of the coated glass fiber strands of the present invention is good processability in weaving and knitting. Low fuzz and halos, low broken filaments, low strand tension, high fliability and low insertion time are characteristics which can be provided by the coated glass fiber strands of the present invention to facilitate weaving and knitting and consistently provide a fabric with few surface defects for printed circuit board applications.

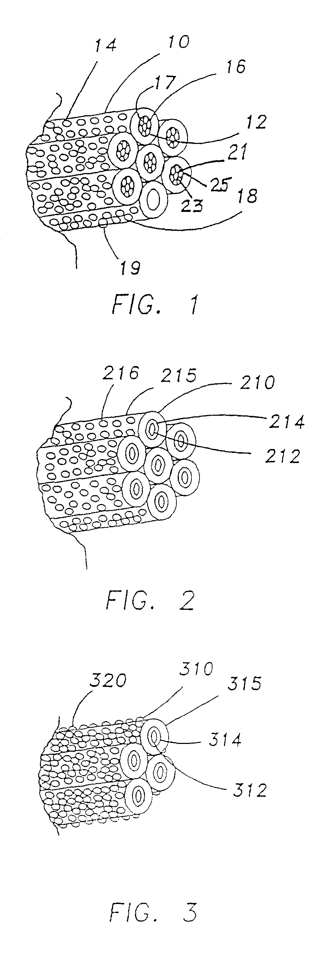

Referring now to Fig. 1, wherein like numerals indicate like elements throughout, there is shown in Fig. 1 a coated fiber strand 10 comprising a plurality of glass fibers 12 or quartz fibers, according to the present invention. As used herein, "strand" means a plurality of individual fibers. The term "fiber" means an individual filament. The fibers 12 have an average nominal fiber diameter greater than 5 micrometers, preferably greater than 7 micrometers, and more preferably greater than 9 micrometers.

The glass fibers 12 can be formed from any type of fiberizable glass composition known to those skilled in the art, including those prepared from fiberizable glass compositions such as "E-glass", "A-glass", "C-glass", "D-glass", "R-glass", "S-glass", and E-glass derivatives. As used herein, "E-glass derivatives" means glass compositions which include minor amounts of fluorine and/or boron and preferably are fluorine-free and/or boron-free. Furthermore, as used herein, minor means less than about 1 weight percent fluorine and less than about 5 weight percent boron. Basalt and mineral wool fibers are examples of other glass fibers useful in the present invention. Preferred glass fibers are formed from E-glass or E-glass derivatives. Such compositions and methods of making glass filaments therefrom are well known to those skilled in the art and further discussion thereof is not believed to be necessary in view of the present disclosure. If additional information is needed, such glass compositions and fiberization methods are disclosed in K. Loewenstein, The Manufacturing Technology of Glass Fibres, (3d Ed. 1993) at pages 30-44, 47-60, 115-122 and 126-135; and U.S. Patent Nos. 4,542,106 and 5,789,329, which are hereby incorporated by reference.

In addition to glass fibers, the coated fiber strand 10 can further comprise fibers formed from other fiberizable natural or man-made materials, such as non-glass inorganic materials, natural materials, organic polymeric materials and combinations thereof. As used herein, the term "fiberizable" means a material capable of being formed into a generally continuous filament, fiber, strand or yarn.

Suitable non-glass inorganic fibers include ceramic fibers formed from silicon carbide, carbon, graphite, mullite, aluminum oxide and piezoelectric ceramic materials. Non-limiting examples of suitable animal and vegetable-derived natural fibers include cotton, cellulose, natural rubber, flax, ramie, hemp, sisal and wool. Suitable man-made fibers include those formed from polyamides (such as nylon and aramids), thermoplastic polyesters (such as polyethylene terephthalate and polybutylene terephthalate), acrylics (such as polyacrylonitriles), polyolefins, polyurethanes and vinyl polymers (such as polyvinyl alcohol). Non-glass fibers believed to be useful in the present invention and methods for preparing and processing such fibers are discussed at length in the Encyclopedia of Polymer Science and Technology, Vol. 6 (1967) at pages 505-712, which is hereby incorporated by reference. It is understood that blends or copolymers of any of the above materials and combinations of fibers formed from any of the above materials can be used in the present invention, if desired.

The present invention will now be discussed generally in the context of glass fiber strands, although one skilled in the art would understand that the strand 10 can additionally include one or more of the non-glass fibers discussed above.

With continued reference to Fig. 1, in a preferred embodiment, fibers 12 of fiber strand 10 of the present invention are impregnated with a primary layer 14 of a dried residue of an aqueous sizing composition applied to at least a portion 17 of the surfaces 16 of the fibers 12 to protect the fiber surfaces 16 from abrasion during processing and inhibit breakage of the fibers 12. Preferably the dried residue of the aqueous sizing composition is applied to the entire outer surface 16 or periphery of the fibers 12.

As used herein, in a preferred embodiment the terms "size", "sized" or "sizing" refer to the coating composition applied to the fibers immediately after formation of the fibers. In an alternative embodiment, the terms "size", "sized" or "sizing" additionally refer to a coating composition (also known as a "finishing size") applied to the fibers after a conventional primary coating composition has been removed by heat or chemical treatment, i.e., the finishing size is applied to bare glass fibers incorporated into a fabric form.

The aqueous sizing composition comprises one or more, and preferably a plurality of, solid particles 18 positioned between or adhered to the outer surfaces 16 of the fibers 12 which provide interstitial spaces 21 between adjacent glass fibers 23, 25 of the strand 10. These interstitial spaces 21 correspond generally to the average particle size 19 of the solid particles 18 positioned between the adjacent fibers. As used herein, "solid" means a substance that does not flow perceptibly under moderate stress has definite capacity for resisting forces which tend to deform it, and under ordinary conditions retains a definite size and shape. See Webster's Third New International Dictionary of the English Language - Unabridged (1971) at page 2169. Furthermore, as used herein, the term "solid" includes both crystalline and non-crystalline materials.

The solid particles 18 have a minimum average particle size 19 (equivalent spherical diameter) of at least 3 micrometers, preferably at least about 5 micrometers, and ranges from 3 to about 1000 micrometers, preferably about 5 to about 1000 micrometers, and more preferably about 10 to about 25 micrometers. Preferably, each of the solid particles has a minimum particle size of at least 3 micrometers, and preferably of at least about 5 micrometers. It is also preferred that the minimum average particle size 19 of the solid particles correspond generally to the average nominal diameter of the glass fibers. It should be appreciated that particle sizes discussed above are preferred over the smaller particle sizes, in part because they are generally less expensive and are easier to disperse. In addition, fabrics made with strands coated with the particles of the sizes as discussed above exhibit better "wet through" and "wet out" characteristics when impregnated with a polymeric matrix material when compared to fabrics made with strands coated with smaller size particles.

The configuration or shape of the solid particles 18 can be generally spherical (such as beads, microbeads or solid hollow spheres), cubic, platy or acicular (elongated or fibrous), as desired. For more information on suitable particle characteristics see H. Katz et al. (Ed.), Handbook of Fillers and Plastics, (1987) at pages 9-10, which are hereby incorporated by reference. The solid particles 18 must maintain their minimum average particle size (equivalent spherical diameter) of at least 3 micrometers, and preferably at least about 5 micrometers, and more particularly maintain their minimum particle size (equivalent spherical diameter) of at least 3 micrometers, and preferably at least about 5 micrometers, under processing conditions, such as the forces generated between adjacent fibers during weaving, roving and other processing operations, to maintain interstitial spaces between adjacent fibers 23, 25. In other words, the solid particles must not crumble, deform or dissolve in the aqueous sizing composition to a particle size less than their minimum average particle size under typical glass fiber processing conditions, such as exposure to temperatures of up to about 25°C, and more preferably up to about 400°C.

Glass fibers are subject to abrasive wear by contact with asperities of adjacent glass fibers and/or other solid objects or materials which the glass fibers contact during forming and subsequent processing, such as weaving or roving. "Abrasive wear", as used herein, means scraping or cutting off of bits of the glass fiber surface or breakage of glass fibers by frictional contact with particles, edges or entities of materials which are hard enough to produce damage to the glass fibers. See K. Ludema, Friction, Wear, Lubrication, (1996) at page 129, which is hereby incorporated by reference. Abrasive wear of glass fiber strands causes strand breakage during processing and surface defects in products such as woven cloth and composites, which increases waste and manufacturing cost.

To minimize abrasive wear, the solid particles have a hardness value which does not exceed, i.e., is less than or equal to, a hardness value of the glass fiber(s). The hardness values of the solid particles and glass fibers can be determined by any conventional hardness measurement method, such as Vickers or Brinell hardness, but is preferably determined according to the original Mohs' hardness scale which indicates the relative scratch resistance of the surface of a material. The Mohs' hardness value of glass fibers generally ranges from about 4.5 to about 6.5, and is preferably about 6. R. Weast (Ed.), Handbook of Chemistry and Physics, CRC Press (1975) at page F-22, which is hereby incorporated by reference. The Mohs' hardness value of the solid particles preferably ranges from about 0.5 to about 6. The Mohs' hardness values of several non-limiting examples of solid particles suitable for use in the present invention are given in Table A below.

**Table A**

| Solid particle material | Mohs' hardness (original scale) |
|---|---|
| boron nitride | about 2² |
| graphite | about 0.5-1³ |
| molybdenum disulfide | about 1⁴ |
| talc | about 1-1.5⁵ |
| mica | about 2.8-3.2⁶ |
| kaolinite | about 2.0-2.5⁷ |
| gypsum | about 1.6-2⁸ |
| calcite (calcium carbonate) | about 3⁹ |
| calcium fluoride | about 4¹⁰ |
| zinc oxide | about 4.5¹¹ |
| aluminum | about 2.5¹² |
| copper | about 2.5-3¹³ |
| iron | about 4-5¹⁴ |
| gold | about 2.5-3¹⁵ |
| nickel | about 5¹⁶ |
| palladium | about 4.8¹⁷ |
| platinum | about 4.3¹⁸ |
| silver | about 2.5-4¹⁹ |

| | |
|---|---|
| ² K. Ludema, Friction, Wear, Lubrication, (1996) at page 27, which is hereby incorporated by reference. | |
| ³ R. Weast (Ed.), Handbook of Chemistry and Physics, CRC Press (1975) at page F-22. | |
| ⁴ R. Lewis, Sr., Hawley's Condensed Chemical Dictionary, (12th Ed. 1993) at page 793, which is hereby incorporated by reference. | |
| ⁵ Hawley's Condensed Chemical Dictionary, (12th Ed. 1993) at page 1113, which is hereby incorporated by reference. | |
| ⁶ Hawley's Condensed Chemical Dictionary, (12th Ed. 1993) at page 784, which is hereby incorporated by reference. | |
| ⁷ Handbook of Chemistry and Physics at page F-22. | |
| ⁸ Handbook of Chemistry and Physics at page F-22. | |
| ⁹ Friction, Wear, Lubrication at page 27. | |
| ¹⁰ Friction, Wear, Lubrication at page 27. | |
| ¹¹ Friction, Wear, Lubrication at page 27. | |
| ¹² Friction, Wear, Lubrication at page 27. | |
| ¹³ Handbook of Chemistry and Physics at page F-22. | |
| ¹⁴ Handbook of Chemistry and Physics at page F-22. | |
| ¹⁵ Handbook of Chemistry and Physics at page F-22 | |
| ¹⁶ Handbook of Chemistry and Physics at page F-22. | |
| ¹⁷ Handbook of Chemistry and Physics at page F-22. | |
| ¹⁸ Handbook of Chemistry and Physics at page F-22 | |
| ¹⁹ Handbook of Chemistry and Physics at page F-22 | |

As mentioned above, the Mohs' hardness scale relates to the resistance of a material to scratching. The instant invention therefore contemplates particles that have a hardness at their surface that is different from the hardness of the internal portions of the particle beneath its surface. More specifically, the surface of the particle can be modified in any manner well known in the art, including but not limited to coating, cladding or encapsulating the particle or chemically changing its surface characteristics using techniques known in the art, such that the surface hardness of the particle is not greater than the hardness of the glass fibers while the hardness of the particle beneath the surface is greater than the hardness of the glass fibers. For example but not limiting the present invention, inorganic particles such as silicon carbide and aluminum nitride can be provided with a silica, carbonate or nanoclay coating. In addition, silane coupling agents with alkyl side chains can be reacted with the surface of many oxide particles to provide a "softer" surface.

Generally, solid particles 18 useful in the present invention can be formed from inorganic materials, organic materials or mixtures thereof. Preferably, the solid particles 18 are formed from inorganic materials selected from the group consisting of ceramic materials and metallic materials. Suitable ceramic materials include metal nitrides, metal oxides, metal carbides, metal sulfides, metal borides, metal silicates, metal carbonates and mixtures thereof.

A non-limiting of a suitable metal nitride is boron nitride, which is the preferred inorganic material from which solid particles useful in the present invention are formed. A non-limiting example of a useful metal oxide is zinc oxide. Suitable metal sulfides include molybdenum disulfide, tantalum disulfide, tungsten disulfide and zinc sulfide. Useful metal silicates include aluminum silicates and magnesium silicates, such as vermiculite. Suitable metallic materials include graphite, molybdenum, platinum, palladium, nickel, aluminum, copper, gold, iron, silver and mixtures thereof.

Preferably the inorganic solid particles 18 are also solid lubricants. As used herein, "solid lubricant" means that the inorganic solid particles 18 have a characteristic crystalline habit which causes them to shear into thin, flat plates which readily slide over one another and thus produce an antifriction lubricating effect between the glass fiber surface and an adjacent solid surface, at least one of which is in motion. See R. Lewis, Sr., Hawley's Condensed Chemical Dictionary, (12th Ed. 1993) at page 712, which is hereby incorporated by reference. Friction is the resistance to sliding one solid over another. F. Clauss, Solid Lubricants and Self-Lubricating Solids, (1972) at page 1, which is hereby incorporated by reference. In a preferred embodiment, the solid lubricant particles have a lamellar structure. Particles having a lamellar or hexagonal crystal structure are composed of sheets or plates of atoms in hexagonal array, with strong bonding within the sheet and weak van der Waals bonding between sheets, providing low shear strength between sheets. Friction, Wear, Lubrication at page 125, Solid Lubricants and Self-Lubricating Solids at pages 19-22, 42-54, 75-77, 80-81, 82, 90-102, 113-120 and 128, and W. Campbell "Solid Lubricants", Boundary Lubrication; An Appraisal of World Literature, ASME Research Committee on Lubrication (1969) at pages 202-203, which are hereby incorporated by reference. Inorganic solid particles having a lamellar fullerene (buckyball) structure are also useful in the present invention.

Non-limiting examples of suitable inorganic solid lubricant particles having a lamellar structure include boron nitride, graphite, metal dichalcogenides, mica, talc, gypsum, kaolinite, calcite, cadmium iodide, silver sulfide and mixtures thereof. Preferred inorganic solid lubricant particles include boron nitride, graphite, metal dichalcogenides and mixtures thereof. Suitable metal dichalcogenides include molybdenum disulfide, molybdenum diselenide, tantalum disulfide, tantalum diselenide, tungsten disulfide, tungsten diselenide and mixtures thereof.

Boron nitride particles having a hexagonal crystal structure are most preferred for use in the aqueous sizing composition. Boron nitride, zinc sulfide and montmorillonite particles also provide good whiteness in composites with polymeric matrix materials such as nylon 6,6.

Non-limiting examples of boron nitride particles suitable for use in the present invention are PolarTherm® 100 Series (PT 120, PT 140, PT 160 and PT 180), 300 Series (PT 350) and 600 Series (PT 620, PT 630, PT 640 and PT 670) boron nitride powder particles which are commercially available from Advanced Ceramics Corporation of Lakewood, Ohio. "PolarTherm® Thermally Conductive Fillers for Polymeric Materials" a technical bulletin of Advanced Ceramics Corporation of Lakewood, Ohio (1996), which is hereby incorporated by reference. These particles have a thermal conductivity of about 250-300 Watts per meter °K at 25°C, a dielectric constant of about 3.9 and a volume resistivity of about 10¹⁵ ohm-centimeters. The 100 Series powder has an average particle size ranging from about 5 to about 14 micrometers, the 300 Series has an average particle size ranging from about 100 to about 150 micrometers and the 600 series has an average particle size ranging from about 16 to greater than about 200 micrometers.

The solid lubricant particles 18 can be present in a dispersion, suspension or emulsion in water. Other solvents, such as mineral oil or alcohol (preferably less than about 5 weight percent), can be included in the sizing composition, if desired. A non-limiting example of a preferred dispersion of about 25 weight percent boron nitride particles in water is ORPAC BORON NITRIDE RELEASECOAT-CONC which is commercially available from ZYP Coatings, Inc. of Oak Ridge, Tennessee. "ORPAC BORON NITRIDE RELEASECOAT-CONC", a technical bulletin of ZYP Coatings, Inc., which is hereby incorporated by reference. According to the supplier, the boron nitride particles in this product have an average particle size of less than about 3 micrometers. This dispersion has about 1 percent of magnesium-aluminum silicate, which according to the supplier binds the boron nitride particles to the substrate to which the dispersion is applied. Other useful products which are commercially available from ZYP Coatings include BORON NITRIDE LUBRICOAT® paint, BRAZE STOP and WELD RELEASE products.

Preferably, the sizing composition is essentially free of hydratable inorganic solid lubricant particles or abrasive silica particles or calcium carbonate, i.e., comprises less than about 20 weight percent of hydratable inorganic lubricant particles, abrasive silica particles or calcium carbonate on a total solids basis, more preferably less than about 5 weight percent, and most preferably less than 0.001 weight percent.

As used herein, "hydratable" means that the solid inorganic lubricant particles react with molecules of water to form hydrates and contain water of hydration or water of crystallization. A "hydrate" is produced by the reaction of molecules of water with a substance in which the H-OH bond is not split. See R. Lewis, Sr., Hawley's Condensed Chemical Dictionary, (12th Ed. 1993) at pages 609-610 and T. Perros, Chemistry, (1967) at pages 186-187, which are hereby incorporated by reference. In the chemical formulas of hydrates, the addition of the water molecules is conventionally indicated by a centered dot, e.g., 3MgO•4SiO₂•H₂O (talc), Al₂O₃•2SiO₂•2H₂O (kaolinite). Hydrates contain coordinated water, which coordinates the cations in the hydrated material and cannot be removed without the breakdown of the structure, and/or structural water, which occupies interstices in the structure to add to the electrostatic energy without upsetting the balance of charge. R. Evans, An Introduction to Crystal Chemistry, (1948) at page 276, which is hereby incorporated by reference.

While not preferred, the aqueous sizing composition can contain hydratable or hydrated inorganic solid lubricant materials in addition to the non-hydratable inorganic solid lubricant materials discussed above. Non-limiting examples of such hydratable inorganic solid lubricant materials are clay mineral phyllosilicates, including micas (such as muscovite), talc, montmorillonite, kaolinite and gypsum (CaSO₄•2H₂O).

In an alternative embodiment, the solid particles 18 can be formed from organic polymeric materials selected from the group consisting of thermosetting materials, thermoplastic materials, starches and mixtures thereof. Suitable thermosetting materials include thermosetting polyesters, vinyl esters, epoxy materials, phenolics, aminoplasts, thermosetting polyurethanes and mixtures thereof, such as are discussed below. Suitable thermoplastic materials include vinyl polymers, thermoplastic polyesters, polyolefins, polyamides, thermoplastic polyurethanes, acrylic polymers and mixtures thereof. Preferred organic solid particles are in the form of microbeads or hollow spheres.

In an alternative preferred embodiment, the solid particles 18 are thermally conductive, i.e., have a thermal conductivity greater than about 30 Watts per meter K, such as for example boron nitride, graphite, and the metallic inorganic solid lubricants discussed above. The thermal conductivity of a solid material can be determined by any method known to one skilled in the art, such as the guarded hot plate method according to ASTM C-177-85 (which is hereby incorporated by reference) at a temperature of about 300K.

In another alternative preferred embodiment, the inorganic solid particles 18 are electrically insulative or have high electrical resistivity, i.e., have an electrical resistivity greater than about 1000 microohm-cm, such as for example boron nitride.

The solid lubricant particles comprises about 0.001 to about 99 weight percent of the sizing composition on a total solids basis, preferably, about 1 to about 80 weight percent, and more preferably about 1 to about 40 weight percent. In a preferred embodiment, the sizing composition can contain greater than 20 to about 40 weight percent boron nitride on total solids basis.

In addition to the solid particles, the aqueous sizing composition preferably comprises one or more polymeric film-forming materials, such as thermosetting materials, thermoplastic materials, starches and mixtures thereof. Preferably the polymeric film-forming materials form a generally continuous film when applied to the surface 16 of the glass fibers. Generally, the amount of polymeric film-forming materials can range from about 1 to about 99 weight percent of the aqueous sizing composition on a total solids basis, preferably about 20 to about 99 weight percent and more preferably about 60 to about 80 weight percent.

Thermosetting polymeric film-forming materials are preferred polymeric film-forming materials for use in the aqueous sizing composition for coating glass fiber strands of the present invention. Such materials are compatible with thermosetting matrix materials used as laminates for printed circuit boards, such as FR-4 epoxy resins, which are polyfunctional epoxy resins and in one particular embodiment of the invention is a difunctional brominated epoxy resins. See 1 Electronic Materials Handbook™, ASM International (1989) at pages 534-537, which are hereby incorporated by reference.

Useful thermosetting materials include thermosetting polyesters, epoxy materials, vinyl esters, phenolics, aminoplasts, thermosetting polyurethanes and mixtures thereof. Suitable thermosetting polyesters include STYPOL polyesters which are commercially available from Cook Composites and Polymers of Port Washington, Wisconsin and NEOXIL polyesters which are commercially available from DSM B.V. of Como, Italy.

In a preferred embodiment, the thermosetting polymeric material is an epoxy material. Useful epoxy materials contain at least one epoxy or oxirane group in the molecule, such as polyglycidyl ethers of polyhydric alcohols or thiols. Examples of suitable epoxy film-forming polymers include EPON® 826 and EPON® 880 epoxy resins, which are commercially available from Shell Chemical Company of Houston, Texas.

Useful thermoplastic polymeric materials include vinyl polymers, thermoplastic polyesters, polyolefins, polyamides (e.g. aliphatic polyamides or aromatic polyamides such as aramid), thermoplastic polyurethanes, acrylic polymers and mixtures thereof. Preferred vinyl polymers useful in the present invention include polyvinyl pyrrolidones such as PVP K-15, PVP K-30, PVP K-60 and PVP K-90, each of which are commercially available from ISP Chemicals of Wayne, New Jersey. Other suitable vinyl polymers include Resyn 2828 and Resyn 1037 vinyl acetate copolymer emulsions which are commercially available from National Starch, and other polyvinyl acetates such as are commercially available from H. B. Fuller and Air Products and Chemicals Co. of Allentown, Pennsylvania.

Thermoplastic polyesters useful in the present invention include DESMOPHEN 2000 and DESMOPHEN 2001KS, both of which are commercially available from Bayer of Pittsburgh, Pennsylvania. A preferred polyester is RD-847A polyester resin which is commercially available from Borden Chemicals of Columbus, Ohio. Useful polyamides include the VERSAMID products which are commercially available from General Mills Chemicals, Inc. Useful thermoplastic polyurethanes include WITCOBOND® W-290H which is commercially available from Witco Chemical Corp. of Chicago, Illinois and RUCOTHANE® 2011L polyurethane latex which is commercially available from Ruco Polymer Corp. of Hicksville, New York.

The aqueous sizing composition can comprise a mixture of one or more thermosetting polymeric materials with one or more thermoplastic polymeric materials. In a preferred embodiment for laminates for printed circuit boards, the polymeric materials of the aqueous sizing composition comprise a mixture of RD-847A polyester resin, PVP K-30 polyvinyl pyrrolidone, DESMOPHEN 2000 polyester and VERSAMID polyamide. In an alternative preferred embodiment suitable for laminates for printed circuit boards, the polymeric materials of the aqueous sizing composition comprise a mixture of EPON 826 epoxy resin and PVP K-30 polyvinyl pyrrolidone.

Useful starches include those prepared from potatoes, corn, wheat, waxy maize, sago, rice, milo and mixtures thereof. A non-limiting example of a useful starch is Kollotex 1250 (a low viscosity, low amylose potato-based starch etherified with ethylene oxide) which is commercially available from AVEBE of the Netherlands.

The polymeric materials can be water soluble, emulsifiable, dispersible and/or curable. As used herein, "water soluble" means that the polymeric materials are capable of being essentially uniformly blended and/or molecularly or ionically dispersed in water to form a true solution. See Hawley's at page 1075, which is hereby incorporated by reference. "Emulsifiable" means that the polymeric materials are capable of forming an essentially stable mixture or being suspended in water in the presence of an emulsifying agent. See Hawley's at page 461, which is hereby incorporated by reference. Non-limiting examples of suitable emulsifying agents are set forth below. "Dispersible" means that any of the components of the polymeric materials are capable of being distributed throughout water as finely divided particles, such as a latex. See Hawley's at page 435, which is hereby incorporated by reference. The uniformity of the dispersion can be increased by the addition of wetting, dispersing or emulsifying agents (surfactants), which are discussed below. "Curable" means that the polymeric materials and other components of the sizing composition are capable of being coalesced into a film or crosslinked to each other to change the physical properties of the polymeric materials. See Hawley's at page 331, which is hereby incorporated by reference.

In addition to or in lieu of the polymeric materials discussed above, the aqueous sizing composition preferably comprises one or more glass fiber coupling agents such as organo silane coupling agents, transition metal coupling agents, phosphonate coupling agents, aluminum coupling agents, amino-containing Werner coupling agents and mixtures thereof. These coupling agents typically have dual functionality. Each metal or silicon atom has attached to it one or more groups which can react or compatibilize with the fiber surface and/or the components of the aqueous sizing composition. As used herein, the term "compatibilize" means that the groups are chemically attracted, but not bonded, to the fiber surface and/or the components of the sizing composition, for example by polar, wetting or solvation forces.

Examples of hydrolyzable groups include: 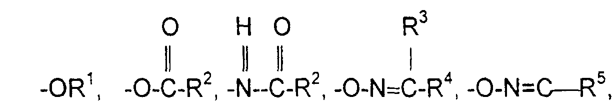 and
the monohydroxy and/or cyclic C₂-C₃ residue of a 1,2- or 1,3 glycol, wherein R¹ is C₁-C₃ alkyl; R² is H or C₁-C₄ alkyl; R³ and R⁴ are independently selected from H, C₁-C₄ alkyl or C₆-C₈ aryl; and R⁵ is C₄-C₇ alkylene. Examples of suitable compatibilizing or functional groups include epoxy, glycidoxy, mercapto, cyano, allyl, alkyl, urethano, halo, isocyanato, ureido, imidazolinyl, vinyl, acrylato, methacrylato, amino or polyamino groups.

Functional organo silane coupling agents are preferred for use in the present invention. Examples of useful functional organo silane coupling agents include gamma-aminopropyltrialkoxysilanes, gamma-isocyanatopropyltriethoxysilane, vinyl-trialkoxysilanes, glycidoxypropyltrialkoxysilanes and ureidopropyltrialkoxysilanes. Preferred functional organo silane coupling agents include A-187 gamma-glycidoxypropyltrimethoxysilane, A-174 gamma-methacryloxypropyltrimethoxysilane, A-1100 gamma-aminopropyltriethoxysilane silane coupling agents, A-1108 amino silane coupling agent and A-1160 gamma-ureidopropyltriethoxysilane (each of which are commercially available from OSi Specialties, Inc. of Tarrytown, New York). The organo silane coupling agent can be at least partially hydrolyzed with water prior to application to the fibers, preferably at about a 1:1 stoichiometric ratio or, if desired, applied in unhydrolyzed form.

Suitable transition metal coupling agents include titanium, zirconium, yttrium and chromium coupling agents. Suitable titanate coupling agents and zirconate coupling agents are commercially available from Kenrich Petrochemical Company. Suitable chromium complexes are commercially available from E.I. duPont de Nemours of Wilmington, Delaware. The amino-containing Werner-type coupling agents are complex compounds in which a trivalent nuclear atom such as chromium is coordinated with an organic acid having amino functionality. Other metal chelate and coordinate type coupling agents known to those skilled in the art can be used herein.

The amount of coupling agent can range from about 1 to about 99 weight percent of the aqueous sizing composition on a total solids basis, and preferably about 1 to about 10 weight percent.

The aqueous sizing composition can further comprise one or more organic lubricants which are chemically different from the polymeric materials discussed above. While the aqueous sizing composition can comprise up to about 60 weight percent organic lubricants, preferably the sizing composition is essentially free of organic lubricants, i.e., contains less than about 20 weight percent of organic lubricants, and more preferably is free of organic lubricants. Such organic lubricants include cationic, non-ionic or anionic lubricants and mixtures thereof, such as amine salts of fatty acids, alkyl imidazoline derivatives such as CATION X, which is commercially available from Rhone Poulenc of Princeton, New Jersey, acid solubilized fatty acid amides, condensates of a fatty acid and polyethylene imine and amide substituted polyethylene imines, such as EMERY® 6717, a partially amidated polyethylene imine commercially available from Henkel Corporation of Kankakee, Illinois.

The aqueous sizing composition can include one or more emulsifying agents for emulsifying or dispersing components of the aqueous sizing composition, such as the inorganic particles. Non-limiting examples of suitable emulsifying agents or surfactants include polyoxyalkylene block copolymers (such as PLURONIC™ F-108 polyoxypropylene-polyoxyethylene copolymer which is commercially available from BASF Corporation of Parsippany, New Jersey), ethoxylated alkyl phenols (such as IGEPAL CA-630 ethoxylated octylphenoxyethanol which is commercially available from GAF Corporation of Wayne, New Jersey), polyoxyethylene octylphenyl glycol ethers, ethylene oxide derivatives of sorbitol esters, polyoxyethylated vegetable oils (such as ALKAMULS EL-719, which is commercially available from Rhone-Poulenc) and nonylphenol surfactants (such as MACOL NP-6 which is commercially available from BASF of Parsippany, New Jersey). Generally, the amount of emulsifying agent can range from about 1 to about 30 weight percent of the aqueous sizing composition on a total solids basis.

The aqueous sizing composition can include one or more aqueous soluble, emulsifiable or dispersible wax materials such as vegetable, animal, mineral, synthetic or petroleum waxes. Preferred waxes are petroleum waxes such as MICHEM® LUBE 296 microcrystalline wax, POLYMEKON® SPP-W microcrystalline wax and PETROLITE 75 microcrystalline wax which are commercially available from Michelman Inc. of Cincinnati, Ohio and the Petrolite Corporation of Tulsa, Oklahoma, respectively. Generally, the amount of wax can be about 1 to about 10 weight percent of the sizing composition on a total solids basis.

Crosslinking materials, such as melamine formaldehyde, and plasticizers, such as phthalates, trimellitates and adipates, can also be included in the aqueous sizing composition. The amount of crosslinker or plasticizer can range from about 1 to about 5 weight percent of the sizing composition on a total solids basis.

Other additives can be included in the aqueous sizing composition, such as silicones, fungicides, bactericides and anti-foaming materials, generally in an amount of less than about 5 weight percent. Organic and/or inorganic acids or bases in an amount sufficient to provide the aqueous sizing composition with a pH of about 2 to about 10 can also be included in the sizing composition. A non-limiting example of a suitable silicone emulsion is LE-9300 epoxidized silicone emulsion which is commercially available from OSi Specialties, Inc. of Danbury, Connecticut. An example of a suitable bactericide is Biomet 66 antimicrobial compound, which is commercially available from M & T Chemicals of Rahway, New Jersey. Suitable anti-foaming materials are the SAG materials which are commercially available from OSi Specialties, Inc. of Danbury, Connecticut and MAZU DF-136, which is available from BASF Company of Parsippany, New Jersey. Ammonium hydroxide can be added to the sizing composition for sizing stabilization, if desired. Water (preferably deionized) is included in the aqueous sizing composition in an amount sufficient to facilitate application of a generally uniform coating upon the strand. The weight percentage of solids of the aqueous sizing composition generally ranges from about 1 to about 20 weight percent.

The aqueous sizing composition is preferably essentially free of glass materials. As used herein, "essentially free of glass materials" means that the sizing composition comprises less than 20 volume percent of glass matrix materials for forming glass composites, preferably less than about 5 volume percent, and more preferably is free of glass materials. Examples of such glass matrix materials include black glass ceramic matrix materials or aluminosilicate matrix materials such as are well known to those skilled in the art.

In a preferred embodiment for weaving fabric for laminated printed circuit boards, the glass fibers of the coated fiber strands of the present invention have applied thereto a primary layer of a dried residue of an aqueous sizing composition comprising PolarTherm® 160 boron nitride powder and/or BORON NITRIDE RELEASECOAT dispersion, EPON 826 epoxy film-forming material, PVP K-30 polyvinyl pyrrolidone, A-187 epoxy-functional organo silane coupling agent, ALKAMULS EL-719 polyoxyethylated vegetable oil, IGEPAL CA-630 ethoxylated octylphenoxyethanol, KESSCO PEG 600 polyethylene glycol monolaurate ester which is commercially available from Stepan Company of Chicago, Illinois and EMERY® 6717 partially amidated polyethylene imine.

In a more preferred embodiment for weaving cloth, glass fibers of the coated fiber strands of the present invention have applied thereto a primary layer of a dried residue of an aqueous sizing composition comprising PolarTherm® 160 boron nitride powder and/or BORON NITRIDE RELEASECOAT dispersion, RD-847A polyester, PVP K-30 polyvinyl pyrrolidone, DESMOPHEN 2000 polyester, A-174 acrylic-functional organo silane coupling agents and A-187 epoxy-functional organo silane coupling agents, PLURONIC F-108 polyoxypropylene-polyoxyethylene copolymer, MACOL NP-6 nonylphenol surfactant, VERSAMID 140 and LE-9300 epoxidized silicone emulsion.

The aqueous sizing compositions of the present invention can be prepared by any suitable method such as conventional mixing well known to those skilled in the art. Preferably the components discussed above are diluted with water to have the desired weight percent solids and mixed together. Powdered solid particles can be premixed with water or added to the polymeric material prior to mixing with the other components of the sizing.

The primary layer of sizing can be applied in many ways, for example by contacting the filaments with a roller or belt applicator, spraying or other means. The sized fibers are preferably dried at room temperature or at elevated temperatures. The dryer removes excess moisture from the fibers and, if present, cures any curable sizing composition components. The temperature and time for drying the glass fibers will depend upon such variables as the percentage of solids in the sizing composition, components of the sizing composition and type of glass fiber. The sizing composition is typically present as a dried residue on the fibers in an amount between about 0.1 percent and about 5 percent by weight after drying.

The fibers are gathered into strands having 2 to about 15,000 fibers per strand, and preferably about 100 to about 1600 fibers per strand. The average filament diameter of the fibers can range from about 3 to about 30 micrometers.

A secondary layer of a secondary coating composition can be applied over the primary layer in an amount effective to coat or impregnate the portion of the strands, for example by dipping the strand in a bath containing the composition, spraying the composition upon the strand or by contacting the strand with an applicator as discussed above. The coated strand can be passed through a die to remove excess coating composition from the strand and/or dried as discussed above for a time sufficient to at least partially dry or cure the secondary coating composition. The method and apparatus for applying the secondary coating composition to the strand is determined in part by the configuration of the strand material. The strand is preferably dried after application of the secondary coating composition in a manner well known in the art.

Suitable secondary coating compositions can include one or more film-forming materials, lubricants and other additives such as are discussed above. The secondary coating is different from the sizing composition, i.e., it (1) contains at least one component which is chemically different from the components of the sizing composition; or (2) contains at least one component in an amount which is different from the amount of the same component contained in the sizing composition. Non-limiting examples of suitable secondary coating compositions including polyurethane are disclosed in U.S. Patent Nos. 4,762,750 and 4,762,751, which are hereby incorporated by reference.

Referring now to Fig. 2, in an alternative preferred embodiment according to the present invention, the glass fibers 212 of the coated fiber strand 210 can having applied thereto a primary layer 214 of a dried residue of a sizing composition which can include any of the sizing components in the amounts discussed above. Examples of suitable sizing compositions are set forth in Loewenstein at pages 237-291 (3d Ed. 1993) and U.S. Patent Nos. 4,390,647 and 4,795,678, each of which is hereby incorporated by reference. A secondary or principal layer 215 of an aqueous secondary coating composition is applied to at least a portion, and preferably over the entire outer surface, of the primary layer 214. The aqueous secondary coating composition comprises one or more types of solid particles 216 such as are discussed in detail above. Preferably, the solid particles in the secondary coating composition are non-hydratable, lamellar inorganic lubricant particles such as boron nitride which are discussed above. The amount of inorganic lubricant particles in the secondary coating composition can range from about 1 to about 99 weight percent on a total solids basis and preferably about 20 to about 90 weight percent. The percentage of solids of the aqueous secondary coating composition generally ranges from about 5 to about 50 weight percent.

In an alternative embodiment, the solid particles of the secondary coating composition comprise hydrophilic inorganic solid particles which absorb and retain water in the interstices of the hydrophilic particles. The hydrophilic inorganic solid particles can absorb water or swell when in contact with water or participate in a chemical reaction with the water to form, for example, a viscous gel-like solution which blocks or inhibits further ingress of water into the interstices of a telecommunications cable which the coated glass fiber strand is used to reinforce. As used herein, "absorb" means that the water penetrates the inner structure or interstices of the hydrophilic material and is substantially retained therein. See Hawley's Condensed Chemical Dictionary at page 3, which is hereby incorporated by reference. "Swell" means that the hydrophilic particles expand in size or volume. See Webster's New Collegiate Dictionary (1977) at page 1178, which is hereby incorporated by reference. Preferably, the hydrophilic particles swells after contact with water to at least one and one-half times their original dry weight, and more preferably about two to about six times their original weight. Non-limiting examples of hydrophilic inorganic solid lubricant particles which swell include smectites such as vermiculite and montmorillonite, absorbent zeolites and inorganic absorbent gels. Preferably, these hydrophilic particles are applied in powder form over tacky sizing or other tacky secondary coating materials. The amount of hydrophilic inorganic particles in this embodiment of the secondary coating composition can range from about 1 to about 99 weight percent on a total solids basis and preferably about 20 to about 90 weight percent.

In an alternative embodiment shown in Fig. 3, a tertiary layer 320 of a tertiary coating composition can be applied to at least a portion of the surface, and preferably over the entire surface, of a secondary layer 315, i.e., such a fiber strand 312 would have a primary layer 314 of sizing, a secondary layer 315 of a secondary coating composition and a tertiary, outer layer 320 of the tertiary coating. The tertiary coating is different from the sizing composition and the secondary coating composition, i.e., the tertiary coating composition (1) contains at least one component which is chemically different from the components of the sizing and secondary coating composition; or (2) contains at least one component in an amount which is different from the amount of the same component contained in the sizing or secondary coating composition.

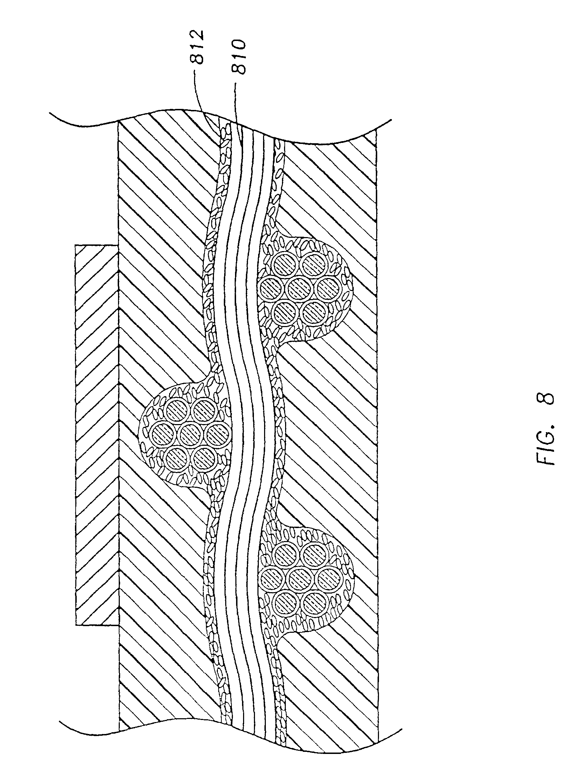

In this embodiment, the secondary coating composition comprises one or more polymeric materials discussed above, such as polyurethane, and the tertiary powdered coating composition comprises powdered solid particles, such as the PolarTherm® boron nitride particles which are discussed above. Preferably, the powdered coating is applied by passing the strand having a liquid secondary coating composition applied thereto through a fluidized bed or spray device to adhere the powder particles to the tacky secondary coating composition. Alternatively, the strands can be assembled into a fabric 810 before the layer 812 of tertiary coating is applied, as shown in Fig. 8. The weight percent of powdered solid particles adhered to the coated fiber strand 310 can range from about 0.1 to about 30 weight percent of the total weight of the dried strand.

The tertiary powdered coating can also include one or more polymeric materials such as are discussed above, such as acrylic polymers, epoxies, or polyolefins, conventional stabilizers and other modifiers known in the art of such coatings, preferably in dry powder form.

The coated fiber strands 10, 210, 310 discussed above can be used as continuous strand or further processed into diverse products such as chopped strand, twisted strand, roving and/or fabric, such as wovens, non-wovens, knits and mats.

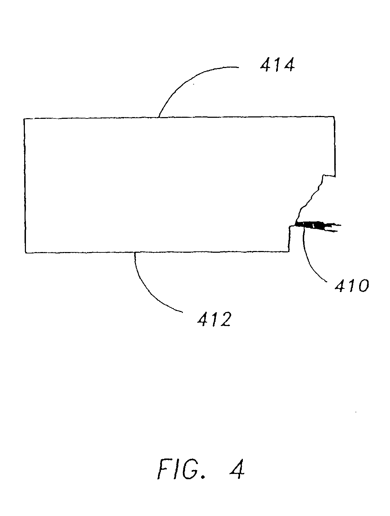

The coated fiber strands 10, 210, 310 and products formed therefrom can be used in a wide variety of applications, but are preferably used as reinforcements 410 for reinforcing polymeric matrix materials 412 to form a composite 414, such as is shown in Fig. 4, which will be discussed in detail below. Such applications include but are not limited to laminates for printed circuit boards, reinforcements for telecommunications cables, and various other composites. An advantage of the impregnated strands of the present invention is that the solid particles provide interstices between the fibers of the strand which facilitate flow of the matrix materials therebetween to more quickly and/or uniformly wet-out and wet-through the fibers of the strand. Surprisingly, the amount of solid particles can exceed 20 weight percent of the total solids of the coating composition applied to the fibers, yet still be adequately adhered to the fibers and provide strands having handling characteristics at least comparable to strands without the solid particle coating.

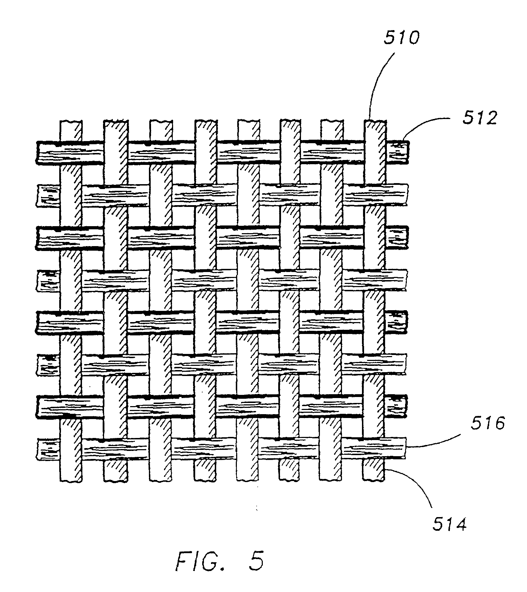

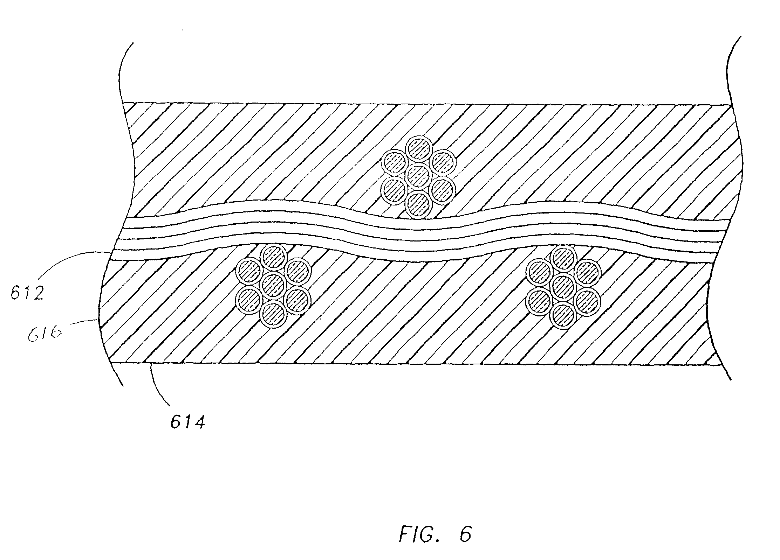

In a preferred embodiment shown in Fig. 5, coated fiber strands 510 made according to the present invention can be used as warp and/or weft strands 514, 516 in a knit or woven fabric 512 reinforcement, preferably to form a laminate for a printed circuit board (shown in Figs. 6-8). The warp strands 514 can be twisted prior to secondary coating by any conventional twisting technique known to those skilled in the art, for example by using twist frames to impart twist to the strand at about 0.5 to about 3 turns per inch. The reinforcing fabric 512 can include about 5 to about 50 warp strands 514 and preferably has about 3 to about 25 picks per centimeter (about 1 to about 15 picks per inch) of the weft strand 516. A suitable woven reinforcing fabric 512 can be formed by using any conventional loom well known to those skilled in the art, such as a shuttle loom, air jet loom or rapier loom. A preferred loom is a Tsudakoma loom which is commercially available from Tsudakoma of Japan. The weave construction can be a regular plain weave or mesh (shown in Fig. 5), although any other weaving style well known to those skilled in the art, such as a twill weave or satin weave, can be used.

Referring now to Fig. 6, the fabric 612 can be used to form a composite or laminate 614 by coating and/or impregnating with a polymeric film-forming thermoplastic or thermosetting matrix material 616. The composite or laminate 614 is suitable for use as a electronic support. As used herein, "electronic support" means a structure that mechanically supports and/or electrically interconnects elements including but not limited to active electronic components, passive electronic components, printed circuits, integrated circuits, semiconductor devices and other hardware associated with such elements including but not limited to connectors, sockets, retaining clips and heat sinks.

Matrix materials useful in the present invention include thermosetting materials such as thermosetting polyesters, vinyl esters, epoxides (containing at least one epoxy or oxirane group in the molecule, such as polyglycidyl ethers of polyhydric alcohols or thiols), phenolics, aminoplasts, thermosetting polyurethanes, derivatives and mixtures thereof. Preferred matrix materials for forming laminates for printed circuit boards are FR-4 epoxy resins, polyimides and liquid crystalline polymers, the compositions of which are well know to those skilled in the art. If further information regarding such compositions is needed, see 1 Electronic Materials Handbook™, ASM International (1989) at pages 534-537.

Non-limiting examples of suitable polymeric thermoplastic matrix materials include polyolefins, polyamides, thermoplastic polyurethanes and thermoplastic polyesters, vinyl polymers and mixtures thereof. Further examples of useful thermoplastic materials include polyimides, polyether sulfones, polyphenyl sulfones, polyetherketones, polyphenylene oxides, polyphenylene sulfides, polyacetals, polyvinyl chlorides and polycarbonates.

Other components which can be included with the polymeric matrix material and reinforcing material in the composite include colorants or pigments, lubricants or processing aids, ultraviolet light (UV) stabilizers, antioxidants, other fillers and extenders.

The fabric 612 can be coated and impregnated by dipping the fabric 612 in a bath of the polymeric matrix material 616, for example, as discussed in R. Tummala (Ed.), Microelectronics Packaging Handbook, (1989) at pages 895-896, which are hereby incorporated by reference. More generally, chopped or continuous fiber strand reinforcing material can be dispersed in the matrix material by hand or any suitable automated feed or mixing device which distributes the reinforcing material generally evenly throughout the polymeric matrix material. For example, the reinforcing material can be dispersed in the polymeric matrix material by dry blending all of the components concurrently or sequentially.

The polymeric matrix material 616 and strand can be formed into a composite or laminate 614 by a variety of methods which are dependent upon such factors as the type of polymeric matrix material used. For example, for a thermosetting matrix material, the composite can be formed by compression or injection molding, pultrusion, filament winding, hand lay-up, spray-up or by sheet molding or bulk molding followed by compression or injection molding. Thermosetting polymeric matrix materials can be cured by the inclusion of crosslinkers in the matrix material and/or by the application of heat, for example. Suitable crosslinkers useful to crosslink the polymeric matrix material are discussed above. The temperature and curing time for the thermosetting polymeric matrix material depends upon such factors as the type of polymeric matrix material used, other additives in the matrix system and thickness of the composite, to name a few.

For a thermoplastic matrix material, suitable methods for forming the composite include direct molding or extrusion compounding followed by injection molding. Methods and apparatus for forming the composite by the above methods are discussed in I. Rubin, Handbook of Plastic Materials and Technology (1990) at pages 955-1062, 1179-1215 and 1225-1271, which are hereby incorporated by reference.

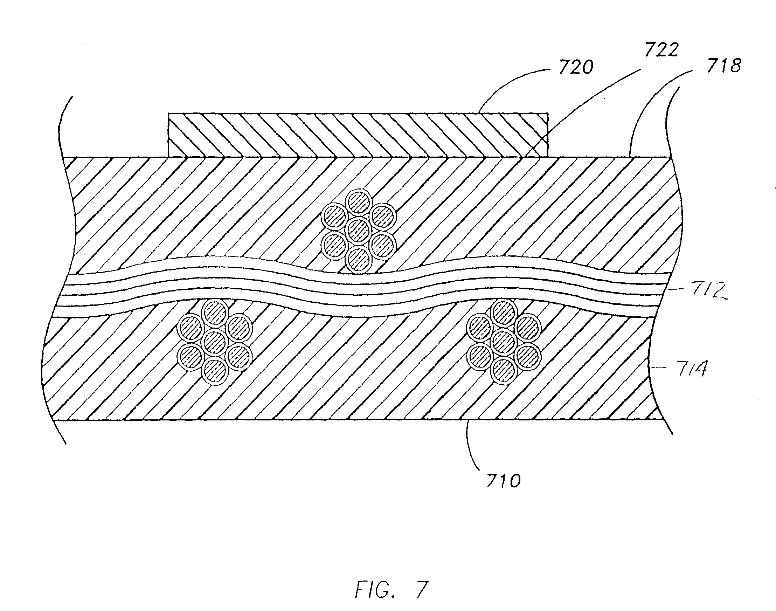

In a particular embodiment of the invention shown in Fig. 7, composite or laminate 710 includes fabric 712 impregnated with a compatible matrix material 714. The impregnated fabric can then be squeezed between a set of metering rolls to leave a measured amount of matrix material, and dried to form an electronic support in the form of a semicured substrate or prepreg. An electrically conductive layer 720 can be positioned along a portion of a side 722 of the prepreg in a manner to be discussed below in the specification, and the prepreg is cured to form an electronic support 718 with an electrically conductive layer. In another embodiment of the invention, and more typically in the electronic support industry, two or more prepregs are combined with an electrically conductive layer and laminated together and cured in a manner well known to those skilled in the art, to form a multilayered electronic support. For example, but not limiting the present invention, the prepreg stack can be laminated by pressing the stack, e.g. between polished steel plates, at elevated temperatures and pressures for a predetermined length of time to cure the polymeric matrix and form a laminate of a desired thickness. A portion of one or more of the prepregs can be provided with an electrically conductive layer either prior to or after lamination and curing such that the resulting electronic support is a laminate having at least one electrically conductive layer along a portion of an exposed surface (hereinafter referred to as a "clad laminate").

Circuits can then be formed from the electrically conductive layer(s) of the single layer or multilayered electronic support using techniques well known in the art to construct an electronic support in the form of a printed circuit board or printed wiring board (hereinafter collectively referred to as "electronic circuit boards"). If desired, apertures or holes (also referred to as "vias") can be formed in the electronic supports, to allow for electrical interconnection between circuits and/or components on opposing surfaces of the electronic support, by any convenient manner known in the art, including but not limited to mechanical drilling and laser drilling. More specifically, after formation of the apertures, a layer of electrically conductive material is deposited on the walls of the aperture or the aperture is filled with an electrically conductive material to facilitate the required electrical interconnection and/or heat dissipation.

The electrically conductive layer 720 can be formed by any method well known to those skilled in the art. For example but not limiting the present invention, the electrically conductive layer can be formed by laminating a thin sheet or foil of metallic material onto at least a portion of a side of the semi-cured or cured prepreg or laminate. As an alternative, the electrically conductive layer can be formed by depositing a layer of metallic material onto at least a portion of a side of the semi-cured or cured prepreg or laminate using well known techniques including but not limited to electrolytic plating, electroless plating or sputtering. Metallic materials suitable for use as an electrically conductive layer include but are not limited to copper (which is preferred), silver, aluminum, gold, tin, tin-lead alloys, palladium and combinations thereof.

In another embodiment of the present invention, the electronic support can be in the form of a multilayered electronic circuit board constructed by laminating together one or more electronic circuit boards (described above) with one or more clad laminates (described above) and/or one or more prepregs (described above). If desired, additional electrically conductive layers can be incorporated into the electronic support, for example along a portion of an exposed side of the multilayered electronic circuit board. Furthermore, if required, additional circuits can be formed from the electrically conductive layers in a manner discussed above. It should be appreciated that depending on the relative positions of the layers of the multilayered electronic circuit board, the board can have both internal and external circuits. Additional apertures are formed, as discussed earlier, partially through or completely through the board to allow electrical interconnection between the layers at selected locations. It should be appreciated that the resulting structure can have some apertures that extend completely through the structure, some apertures that extend only partially through the structure, and some apertures that are completely within the structure.

The instant invention further contemplates the fabrication of multilayered laminates and electronic circuit boards which include at least one composite layer made according to the teachings herein and at least one composite layer made in a manner different from the composite layer taught herein, e.g. made using conventional glass fiber composite technology. More specifically and as is well known to those skilled in the art, traditionally the filaments in continuous glass fiber strands used in weaving fabric are treated with a starch/oil sizing which includes partially or fully dextrinized starch or amylose, hydrogenated vegetable oil, a cationic wetting agent, emulsifying agent and water, including but not limited to those disclosed in Loewenstein at pages 237-244 (3d Ed. 1993), which is hereby incorporated by reference. Warp yarns produced from these strands are thereafter treated with a solution prior to weaving to protect the strands against abrasion during the weaving process, e.g. poly(vinyl alcohol) as disclosed in U.S. Patent No. 4,530,876 at column 3, line 67 through column 4, line 11, which is hereby incorporated by reference. This operation is commonly referred to as slashing. The poly(vinyl alcohol) as well as the starch/oil size are generally not compatible with the polymeric matrix material used by composite manufacturers and the fabric must be cleaned to remove essentially all organic material from the surface of the glass fibers prior to impregnating the woven fabric. This can be accomplished in a variety ways, for example by scrubbing the fabric or, more commonly, by heat treating the fabric in a manner well known in the art. As a result of the cleaning operation, there is no suitable interface between the polymeric matrix material used to impregnate the fabric and the cleaned glass fiber surface, so that a coupling agent must be applied to the glass fiber surface. This operation is sometime referred to by those skilled in the art as finishing. The coupling agents most commonly used in finishing operations are silanes, including but not limited to those disclosed in E. P. Plueddemann, Silane Coupling Agents (1982) at pages 146-147, which is hereby incorporated by reference. Also see Loewenstein at pages 249-256 (3d Ed. 1993). After treatment with the silane, the fabric is impregnated with a compatible polymeric matrix material, squeezed between a set of metering rolls and dried to form a semicured prepreg as discussed above. It should be appreciated that depending on the nature of the sizing, the cleaning operation and/or the matrix resin used in the composite, the slashing and/or finishing steps can be eliminated. One or more prepregs incorporating conventional glass fiber composite technology can then be combined with one or more prepregs incorporating the instant invention to form an electronic support as discussed above, and in particular a multilayered laminate or electronic circuit board. For more information regarding fabrication of electronic circuit boards, see 1 Electronic Materials Handbook™, ASM International (1989) at pages 113-115, R. Tummala (Ed.), Microelectronics Packaging Handbook, (1989) at pages 858-861 and 895-909, M. W. Jawitz, Printed Circuit Board Handbook (1997) at pages 9.1-9.42, and C. F. Coombs, Jr. (Ed.), Printed Circuits Handbook, (3d Ed. 1988), pages 6.1-6.7, which are hereby incorporated by reference.

The composites and laminates forming the electronic supports of the instant invention can be used to form packaging used in the electronics industry, and more particularly first, second and/or third level packaging, such as that disclosed in Tummala at pages 25-43, which is hereby incorporated by reference. In addition, the present invention can also be used for other packaging levels.

The present invention also includes a method for reinforcing a polymeric matrix material to form a composite. The method comprises: (1) applying to a glass fiber strand reinforcing material the above sizing, secondary coating and/or tertiary coating composition including inorganic solid particles which provide interstitial spaces between adjacent glass fibers of the strand, the solid particles having a minimum average particle size of at least 3 micrometers, and preferably at least about 5 micrometers, and a Mohs' hardness which is less than a Mohs' hardness of the glass fibers; (2) drying the coating to form a substantially uniform coating upon the reinforcing material; (3) combining the reinforcing material with the polymeric matrix material; and (4) at least partially curing the polymeric matrix material to provide a reinforced polymeric composite in a manner such as is discussed in detail above. Although not limiting the present invention, the reinforcing material can be combined with the polymeric matrix material, for example by dispersing it in the matrix material.

The present invention also includes a method for inhibiting adhesion between adjacent glass fibers of a glass fiber strand, comprising the steps of: (1) applying to a glass fiber strand the above sizing, secondary coating or tertiary coating composition including inorganic solid particles which provide interstitial spaces between adjacent glass fibers of the strand, the solid particles having a minimum average particle size of at least 3 micrometers, and preferably at least about 5 micrometers, and a Mohs' hardness which is less than a Mohs' hardness of the glass fibers; (2) drying the coating to form a substantially uniform coating upon the glass fibers of the glass fiber strand, such that adhesion between adjacent glass fibers of the strand is inhibited.

The present invention will now be illustrated by the following specific, non-limiting examples.

### EXAMPLE 1

Each of the components in the amounts set forth in Table 1 were mixed to form aqueous forming size compositions K through N according to the present invention. Each aqueous forming size composition was prepared in a similar manner to that discussed above. Less than about 1 weight percent of acetic acid on a total weight basis was included in each composition.

Each of the aqueous forming size compositions of Table 1 was coated onto 2G-18 E-glass fiber strands. Each of the forming size compositions had about 10 weight percent solids.

**Table 1**

| | WEIGHT PERCENT OF COMPONENT ON TOTAL SOLIDS BASIS | | | | |
|---|---|---|---|---|---|
| | Sample No. | | | | |
| COMPONENT | K | L | M | N | Comparative Sample |
| Thermoplastic polyurethane film-forming polymer²⁰ | 34.4 | 34.2 | 33.4 | 31.35 | 34.5 |
| Thermoplastic polyurethane film-forming polymer²¹ | 51.5 | 51.2 | 50.18 | 46.9 | 51.7 |
| polyoxyalkylene polyol copolymer | 0.3 | 0.3 | 0.3 | 0.3 | 0.33 |
| epoxidized polyester lubricant | 7.2 | 7.1 | 7.0 | 6.55 | 7.22 |
| Gamma-aminopropyl triethoxysilane coupling agent | 2.7 | 2.7 | 2.7 | 2.5 | 2.76 |
| Gamma-ureidopropyl triethoxysilane coupling agent | 3.3 | 3.3 | 3.2 | 3.0 | 3.34 |
| amino-functional organo silane coupling agent | 0.1 | 0.1 | 0.1 | 0.1 | 0.14 |
| Boron nitride particles in aqueous suspension²² | 0.1 | 1.0 | 2.9 | 9.1 | 0 |
| loss on ignition (%) | 1.11 | 1.14 | 1.05 | 1.08 | 1.17 |

| | | | | | |
|---|---|---|---|---|---|
| ²⁰ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | | | |
| ²¹ Thermoplastic polyester-based polyurethane aqueous dispersion having a solids content of 62 percent, pH of about 10 and average particle size ranging from about 0.8 to about 2 5 microns. | | | | | |
| ²² ORPAC BORON NITRIDE RELEASECOAT-CONC boron nitride particles in aqueous dispersion which is commercially available from ZYP Coatings, Inc. of Oak Ridge, Tennessee | | | | | |

Composite samples of each of the above coated glass fiber samples and the Comparative Sample were extrusion molded at 270°C for 48 seconds at about 7 MPa (975 psi) to produce 254 x 254 x 3.175 millimeters (10 x 10 x 0.125 inches) plaques. Each specimen was evaluated for: tensile strength, tensile elongation and tensile modulus according to ASTM Method D-638M; flexural strength and flexural modulus according to ASTM Method D-790; and notched and unnotched Izod impact strength according to ASTM Method D-256 at the glass contents specified below.

Table 2 presents the results of tests conducted on composites formed using a conventional nylon 6,6 matrix resin

**TABLE 2**

| | units | K | L | M | N | Comp. Sample |
|---|---|---|---|---|---|---|
| Tensile Strength | kpsi | 27.1 | 27.6 | 27.3 | 27.4 | 26.2 |
| | MPa | 186.9 | 190.34 | 188.27 | 188.96 | 180.68 |
| Tensile Elongation | % | 3.32 | 3.37 | 3.36 | 3.42 | 3.32 |
| Tensile Modulus | mpsi | 1.48 | 1.55 | 1.47 | 1.44 | 1.51 |
| | GPa | 10.2 | , 10.7 | 10.1 | 9.9 | 10.4 |
| Flexural Strength | kpsi | 44.6 | 46.3 | 45.7 | 45.5 | 44.0 |
| | MPa | 307.6 | 319.3 | 315.2 | 313.8 | 303.4 |
| Flexural Modulus | mpsi | 1.52 | 1.56 | 1.54 | 1.54 | 1.5 |
| | GPa | 10.5 | 10.7 | 10.6 | 10.6 | 10.6 |
| notched IZOD Impact | ft lb_{f}/in | 1.86 | 2.24 | 1.94 | 1.63 | 1.16 |
| | kJ/m² | 7.89 | 9.50 | 8.23 | 6.91 | 4.92 |
| unnotched IZOD Impact | I ft lb_{f}/in | 21.8 | 22.9 | 21.1 | 20.5 | 22.0 |
| | kJ/m² | 92.43 | 97.10 | 89.46 | 86.92 | 93.28 |
| Glass content | % | 32.9 | 32.6 | 32.4 | 32.3 | 32.4 |

As shown in Table 2, glass fiber strands coated with boron nitride particles (Samples K-N) according to the present invention exhibit improved tensile strength and notched Izod impact properties and similar tensile elongation and modulus, flexural strength and modulus and unnotched Izod impact properties when compared to a comparative sample having similar components which did not contain boron nitride in nylon 6,6 reinforcement. When evaluated using nylon 6 resin under similar conditions, the improvements in tensile strength and notched Izod impact properties were not observed.

### EXAMPLE 2

Each of the components in the amounts set forth in Table 3 were mixed to form aqueous forming size compositions P through S according to the present invention. Each aqueous forming size composition was prepared in a similar manner to that discussed above. Less than about 1 weight percent of acetic acid on a total weight basis was included in each composition.

Each of the aqueous forming size compositions of Table 3 was coated onto G-31 E-glass fiber strands. Each of the forming size compositions had about 10 weight percent solids.

**Table 3**

| | WEIGHT PERCENT OF COMPONENT ON TOTAL SOLIDS BASIS | | | |
|---|---|---|---|---|
| | Sample No. | | | |
| COMPONENT | P | Q | R | S |
| Thermoplastic polyurethane film-forming polymer²³ | 23 | 28.75 | 28.75 | 23 |
| Thermoplastic polyurethane film-forming polymer²⁴ | 34.45 | 43.1 | 43.1 | 34.45 |
| polyoxyalkylene polyol copolymer | 0.22 | 0.27 | 0.27 | 0.22 |
| epoxidized polyester lubricant | 4.8 | 6.0 | 6.0 | 4.8 |
| Gamma-aminopropyl triethoxysilane coupling agent | 1.84 | 2.3 | 2.3 | 1.84 |
| Gamma-ureidopropyl triethoxysilane coupling agent | 2.22 | 2.78 | 2.78 | 2.22 |
| amino-functional organo silane coupling agent | 0.1 | 0.12 | 0.12 | 0.1 |
| Boron nitride powder particles²⁵ | 33.3 | 16.7 | 0 | 0 |
| talc powder particles²⁶ | 0 | 0 | 16.7 | 33.3 |
| loss on ignition (%) | 0.52 | 0.81 | 0.80 | 0.64 |

| | | | | |
|---|---|---|---|---|
| ²³ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | | |
| ²⁴ Thermoplastic polyester-based polyurethane aqueous dispersion having a solids content of 62 percent, pH of about 10 and average particle size ranging from about 0.8 to about 2.5 microns. | | | | |
| ²⁵ PolarTherm® PT 160 boron nitride powder particles which are commercially available from Advanced Ceramics Corporation of Lakewood, Ohio. | | | | |
| ²⁶ VANTALC 2003 talc powder particles which are commercially available from R.T. Vanderbilt Company, Inc. of Norwalk, Connecticut. | | | | |

Composite samples of each of the above coated glass fiber samples and the Comparative Sample of Table 1 above were extrusion molded to produce 400 x 400 x 2.5 millimeters (16 x 16 x 0.100 inches) plaques under the conditions set forth in Example 1 above. Each specimen was evaluated for: tensile strength, tensile elongation, tensile modulus, notched and unnotched Izod impact strength as discussed in Example 1 above at the glass contents specified below.

The color tests were performed on composites having a thickness of 3.175 millimeters (1/8 inch) and a diameter of 76.2 millimeters (3 inches) using a Hunter colorimeter Model D25-PC2A. To evaluate material handling characteristics, funnel flow tests were conducted on samples of chopped glass fiber. The funnel was eighteen inches long and had a seventeen inch diameter opening at the top and a two inch opening on the bottom. The funnel was vibrated and the time was recorded for 20 pounds of sample material to flow through the funnel. The PD-104 test evaluates the resistance of the chopped glass fiber sample to filamentation. Sixty grams of sample, 140 grams of an abrasive material (ground walnut shell particles No. 6/10 which are commercially available from Hammon Products Company) and a conventional foam-type antistatic dryer sheet were enclosed in a 4-liter stainless steel beaker and vibrated using a Red Devil paint shaker Model 5400E3 for six minutes. The vibrated material was screened using No. 5 and No. 6 U.S. Standard testing sieves. The weight percent of fuzz material collected on the screens as a percentage of original sample is reported below.

Table 4 presents the results of tests conducted on composites formed using Samples P-S and the Comparative Sample using nylon 6,6 matrix resin.

**TABLE 4**

| | units | P | Q | R | S | Comp. Sample |
|---|---|---|---|---|---|---|
| Tensile Strength | kpsi | 29.5 | 28.6 | 28.7 | 27.7 | 29.6 |
| | MPa | 203.5 | 197.2 | 197.9 | 191.0 | 204.1 |
| Tensile Elongation | % | 3.03 | 3.05 | 2.98 | 2.97 | 3.01 |
| Tensile Modulus | kpsi | 1866 | 1779 | 1720 | 1741 | 1748 |
| | GPa | 12.86 | 12.26 | 11.86 | 12.0 | 12.05 |
| notched IZOD Impact | ft lb_{f}/in | 2.10 | 1.96 | 1.94 | 1.78 | 2.26 |
| | kJ/m² | 8.90 | 8.31 | 8.23 | 7.55 | 9.58 |
| unnotched IZOD Impact | ft lb_{f}/in | 24.9 | 23.4 | 22.8 | 22.2 | 26.4 |
| | kJ/m² | 105.58 | 99.22 | 96.67 | 94.13 | 111.94 |
| Actual Loss on Ignition | % | 0.81 | 0.52 | 0.80 | 0.64 | 1.17 |
| PD 104 | % | 1.3 | 0.7 | 0.1 | 1.4 | 0.1 |
| Funnel Flow | seconds | 13.8 | 15.2 | 15.4 | 23.5 | 13.0 |
| Whiteness Index | | -15.1 | -12.0 | -17.6 | -18.5 | -18.2 |
| Yellowness Index | | 40.0 | 37.5 | 42.5 | 43.4 | 43.6 |
| Glass content | % | 33.30 | 33 | 32.90 | 31.70 | 33.80 |

As shown in Table 4, glass fiber strands coated with boron nitride particles (Samples P-S) according to the present invention exhibit improved whiteness and yellowness and similar tensile strength, elongation and modulus, flexural strength and modulus, and notched and unnotched Izod impact properties when compared to a Comparative Sample having similar components which did not contain boron nitride in nylon 6,6 reinforcement.

### EXAMPLE 3

Each of the components in the amounts set forth in Table 5 were mixed to form aqueous forming size compositions T and U according to the present invention. Each aqueous forming size composition was prepared in a similar manner to that discussed above. Less than about 1 weight percent of acetic acid on a total weight basis was included in each composition. Table 5 presents the results of whiteness and yellowness tests conducted on composites formed using Samples T, U and the Comparative Sample using nylon 6,6 matrix resin. The color tests were performed on composites having a thickness of 3.175 millimeters (1/8 inch) and a diameter of 76.2 millimeters (3 inches) using a Hunter colorimeter Model D25-PC2A.

**Table 5**

| | WEIGHT PERCENT OF COMPONENT ON TOTAL SOLIDS BASIS | | |
|---|---|---|---|
| | Sample No. | | |
| COMPONENT | T | U | Comparative Sample |
| Thermoplastic polyurethane film-forming polymer²⁷ | 31.35 | 28.75 | 34.4 |
| Thermoplastic polyurethane film-forming polymer²⁸ | 46.9 | 43.1 | 51.6 |
| polyoxyalkylene polyol copolymer | 0.3 | 0.27 | 0.3 |
| epoxidized polyester lubricant | 6.55 | 6.0 | 7.2 |
| Gamma-aminopropyl triethoxysilane coupling agent | 2.5 | 2.3 | 2.7 |
| Gamma-ureidopropyl triethoxysilane coupling agent | 3.0 | 2.78 | 3.3 |
| amino-functional organo silane coupling agent | 0.1 | 0.12 | 0.1 |
| Boron nitride particles in aqueous suspension²⁹ | 9.1 | 16.7 | 0 |
| Whiteness Index | -16.3 | -15.0 | -20.7 |
| Yellowness Index | 39.3 | 38.1 | 42.7 |

| | | | |
|---|---|---|---|
| ²⁷ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | |
| ²⁸ Thermoplastic polyester-based polyurethane aqueous dispersion having a solids content of 62 percent, pH of about 10 and average particle size ranging from about 0.8 to about 2.5 microns. | | | |
| ²⁹ ORPAC BORON NITRIDE RELEASECOAT-CONC boron nitride particles in aqueous dispersion which is commercially available from ZYP Coatings, Inc. of Oak Ridge. Tennessee | | | |

As is shown in Table 5, Samples T and U, each coated with a sizing composition containing boron nitride particles according to the present invention, had lower whiteness indices in nylon 6,6 than a Comparative Sample of a similar formulation which did not include boron nitride.

### EXAMPLE 4

The components in the amounts set forth in Table 6 were mixed to form aqueous forming size compositions A-D according to the present invention in a similar manner to that discussed above. Less than 1 weight percent of acetic acid was included in each composition.

**Table 6**

| | WEIGHT PERCENT OF COMPONENT ON TOTAL SOLIDS BASIS | | | | |
|---|---|---|---|---|---|
| | SAMPLE NO. | | | | |
| COMPONENT | A | B | C | D | Comp. Sample No. 1 |
| Thermoplastic polyester film-forming polymer³⁰ | 28.6 | 29.1 | 31.58 | 50.71 | 28.9 |
| Thermoplastic polyester film-forming polymer ³¹ | 43.7 | 39.1 | 0 | 0 | 44.1 |
| Epoxy film-forming polymer ³² | 0 | 0 | 21.05 | 0 | 0 |
| Polyvinyl pyrrolidone³³ | 0 | 9.7 | 15.79 | 15.21 | 0 |
| epoxy-functional organo silane coupling agent³⁴ | 2.3 | 2.3 | 8.42 | 8.11 | 2.3 |
| acrylic-functional organo silane coupling agent³⁵ | 4.7 | 4.8 | 0 | 0 | 4.8 |
| amino-functional organo silane coupling agent³⁶ | 0 | 0 | 8.42 | 8,11 | 0 |
| polyoxyalkylene block copolymer³⁷ | 10.7 | 5.6 | 0 | 0 | 10.9 |
| Ethoxylated octylphenoxyethanol³⁸ | 0 | 0 | 4.74 | 6.39 | 0 |
| polyamide³⁹ | 4.8 | 4.8 | 0 | 0 | 4.8 |
| surfactant⁴⁰ | 3.6 | 3.6 | 4.74 | 6.39 | 3.6 |
| Organic lubricant⁴¹ | 0 | 0 | 4.21 | 4.06 | 0 |
| polyoxyethylene polymer⁴² | 0.6 | 0 | 0 | 0 | 0.6 |
| boron nitride powder particles⁴³ | 1.0 | 1.0 | 0 | 0 | 0 |
| boron nitride particles in aqueous suspension⁴⁴ | 0 | 0 | 1.05 | 1,01 | 0 |

| | | | | | |
|---|---|---|---|---|---|
| ³⁰ RD-847A polyester resin which is commercially available from Borden Chemicals of Columbus, Ohio. | | | | | |
| ³¹ DESMOPHEN 2000 polyethylene adipate diol which is commercially available from Bayer of Pittsburgh, Pennsylvania. | | | | | |
| ³² EPI-REZ® 3522-W-66 which is commercially available from Shell Chemical Co. of Houston, Texas. | | | | | |
| ³³ PVP K-30 polyvinyl pyrrolidone which is commercially available from ISP Chemicals of Wayne, New Jersey. | | | | | |
| ³⁴ A-187 gamma-glycidoxypropyltrimethoxysilane which is commercially available from OSi Specialties, Inc. of Tarrytown, New York. | | | | | |
| ³⁵ A-174 gamma-methacryloxypropyltrimethoxysilane which is commercially available from OSi Specialties, Inc. of Tarrytown, New York. | | | | | |
| ³⁶ A-1100 amino-functional organo silane coupling agent which is commercially available from OSi Specialties, Inc. of Tarrytown, New York. | | | | | |
| ³⁷ PLURONIC™ F-108 polyoxypropylene-polyoxyethylene copolymer which is commercially available from BASF Corporation of Parsippany, New Jersey. | | | | | |
| ³⁸ IGEPAL CA-630 ethoxylated octylphenoxyethanol which is commercially available from GAF Corporation of Wayne, New Jersey. | | | | | |
| ³⁹ VERSAMID 140 polyamide which is commercially available from General Mills Chemicals, Inc. | | | | | |
| ⁴⁰ MACOL NP-6 nonylphenol surfactant which is commercially available from BASF of Parsippany, New Jersey. | | | | | |
| ⁴¹ EMERY® 6760 lubricant which is commercially available from Henkel Corporation of Kankakee, Illinois. | | | | | |
| ⁴² POLYOX WSR-301 polyoxyethylene polymer which is commercially available from Union Carbide of Danbury, Connecticut. | | | | | |
| ⁴³ PolarTherm® PT 160 boron nitride powder particles which are commercially available from Advanced Ceramics Corporation of Lakewood. Ohio. | | | | | |
| ⁴⁴ ORPAC BORON NITRIDE RELEASECOAT-CONC boron nitride particles in aqueous dispersion which is commercially available from ZYP Coatings. Inc of Oak Ridge. Tennessee | | | | | |

Aqueous forming size compositions A-D and Comparative Sample No. 1 were coated onto E-glass fiber strands. Each of the forming size compositions had about 2.5 weight percent solids. Each coated glass fiber strand was twisted to form a yarn and wound onto bobbins in a similar manner using conventional twisting equipment.

The yarns of Samples A-D, Comparative Sample No. 1 and a Comparative Sample No. 2⁴⁵ were evaluated for several physical properties, such as loss on ignition (LOI), air jet compatibility (Air Drag), Friction Force and broken filaments.
⁴⁵ PPG Industries, Inc. s 1383 commercially available fiber glass yarn product.

The average loss on ignition (weight percent of solids of the forming size composition divided by the total weight of the glass and dried forming size composition) of three trials of each Sample is set forth in Table 7.

Each yarn was evaluated for Air Drag Force or tension by feeding the yarn at a controlled feed rate of 274 meters (300 yards) per minute through a checkline tension meter, which applied a tension to the yarn, and a Ruti two millimeter diameter air nozzle at an air pressure of 310 kPa (45 pounds per square inch).

The Samples and Comparative Samples were also evaluated for Friction Force by applying a tension of about 30 grams to each yarn sample as the sample is pulled at a rate of 274 meters (300 yards) per minute through a pair of conventional tension measurement devices having a stationary chrome post of about 5 centimeters (2 inches) diameter mounted therebetween to displace the yarn about 5 centimeters from a straight line path between the tension measurement devices. The difference in force in grams is set forth in Table 7 below. The Friction Force test is intended to simulate the frictional forces to which the yarn is subjected during weaving operations.

Each sample and comparative sample was also evaluated for broken filaments using an abrasion tester. Two hundred grams of tension were applied to each test sample as each test sample was pulled at a rate of 0.46 meters (18 inches) per minute for five minutes through an abrasion testing apparatus. Two test runs of each sample and comparative sample were evaluated and the average of the number of broken filaments is reported in Table 7 below. The abrasion tester consisted of two parallel rows of steel reeds, each row being positioned about 1 inch apart. Each test yarn sample was threaded between two adjacent reeds of the first row of reeds, then threaded between two adjacent reeds of the second row of reeds, but displaced a distance of one-half inch between the rows of reeds. The reeds were displaced back and forth over a four inch length in a direction parallel to the direction of yarn travel at a rate of 240 cycles per minute. The results of Air Drag Force, Friction Force and Broken Filaments Under Abrasion for Samples A-D and the comparative samples are set forth in Table 7 below.

**Table 7**

| | Sample | | | | | |
|---|---|---|---|---|---|---|
| | A | B | C | D | Comparative Sample No. 1 | Comparative Sample No. 2 |
| LOI (weight percent) | 0.35 | 0.30 | 0.52 | 0.40 | 0.33 | 0.75 |
| Air Drag (grams) | 68.5 | 84.9 | 37.3 | 47.1 | 36.4 | 19.0 |
| Friction force (grams) | 24.7 | 18.3 | - | - | 23.9 | 38.1 |
| Number of broken filaments per yard of yarn | 2.0 | 1.0 | - | - | 3.8 | 1.0 |

As shown in Table 7, Samples A and B, which are coated with sizing compositions containing boron nitride according to the present invention, had few broken filaments, low frictional force and higher air drag values when compared to the Comparative Samples. Samples C and D also had higher air drag values than the Comparative Samples. The air drag test is a relative test intended to simulate the weft insertion process of an air jet loom in which the yarn is conveyed across the loom by air jet propulsion. Yarns which are more readily filamentized by the air jet provide greater surface area for air jet propulsion, which can facilitate yarn travel across the loom and increase productivity. The air drag values for Samples A-D (samples prepared according to the present invention) are higher than those of the Comparative Samples, which indicates superior air jet compatibility.

### EXAMPLE 5

Each of the components in the amounts set forth in Table 8 were mixed to form aqueous forming size compositions E, F, G and H according to the present invention and the Comparative Sample in a similar manner to that discussed above. Less than about 1 weight percent of acetic acid on a total weight basis was included in each composition.

Each of the aqueous forming size compositions of Table 8 were coated onto G-75 E-glass fiber strands. Each of the forming size compositions had between about 6 and about 25 weight percent solids.

**Table 8**

| | WEIGHT PERCENT OF COMPONENT ON TOTAL SOLIDS BASIS | | | | |
|---|---|---|---|---|---|
| | Sample No. | | | | |
| COMPONENT | E | F | G | H | Comp. Sample |
| Epoxy film-forming polymer⁴⁶ | 16.12 | 63.54 | 16.12 | 63.54 | 60.98 |
| Polyvinyl pyrrolidone⁴⁷ | 1.31 | 5.18 | 1.31 | 5.18 | 4.97 |
| Polyoxyethylated vegetable oil⁴⁸ | 1.63 | 6.44 | 1.63 | 6.44 | 6.18 |
| Ethoxylated octylphenoxyethanol⁴⁹ | 1.63 | 6.44 | 1.63 | 6.44 | 6.18 |
| polyethylene glycol monolaurate ester⁵⁰ | 0.79 | 3.11 | 0.79 | 3.11 | 2.98 |
| Epoxy-functional organo silane coupling agent⁵¹ | 3.17 | 12.51 | 3.17 | 12.51 | 12.00 |
| Organic lubricant⁵² | 0.40 | 1.56 | 0.40 | 1.56 | 1.50 |
| polyethylene emulsion⁵³ | 0 | 0 | 0 | 0 | 4.61 |
| Boron nitride powder particles⁵⁴ | 74.78 | 1.00 | 0 | 0 | 0 |
| Boron nitride particles in aqueous suspension⁵⁵ | 0 | 0 | 74.78 | 1.00 | 0 |

| | | | | | |
|---|---|---|---|---|---|
| ⁴⁶ EPON 826 which is commercially available from Shell Chemical of Houston, Texas. | | | | | |
| ⁴⁷ PVP K-30 polyvinyl pyrrolidone which is commercially available from ISP Chemicals of Wayne, New Jersey. | | | | | |
| ⁴⁸ ALKAMULS EL-719 polyoxyethylated vegetable oil which is commercially available from Rhone-Poulenc. | | | | | |
| ⁴⁹ IGEPAL CA-630 ethoxylated octylphenoxyethanol which is commercially available from GAF Corporation of Wayne, New Jersey. | | | | | |
| ⁵⁰ KESSCO PEG 600 polyethylene glycol monolaurate ester which is commercially available from Stepan Company of Chicago, Illinois. | | | | | |
| ⁵¹ A-187 gamma-glycidoxypropyltrimethoxysilane which is commercially available from OSi Specialties, Inc. of Tarrytown, New York. | | | | | |
| ⁵² EMERY® 6717 partially amidated polyethylene imine which is commercially available from Henkel Corporation of Kankakee, Illinois. | | | | | |
| ⁵³ Protolube HD high density polyethylene emulsion which is commercially available from Sybron Chemicals of Birmingham, New Jersey. | | | | | |
| ⁵⁴ PolarTherm® PT 160 boron nitride powder particles which are commercially available from Advanced Ceramics Corporation of Lakewood, Ohio. | | | | | |
| ⁵⁵ ORPAC BORON NITRIDE RELEASECOAT-CONC boron nitride particles in aqueous dispersion which is commercially available from ZYP Coatings. Inc of Oak Ridge, Tennessee | | | | | |

Each coated glass fiber strand was twisted to form yarn and wound onto bobbins in a similar manner using conventional twisting equipment. The yarns of Samples F and H exhibited minimal sizing shedding during twisting and the yarns of Samples E and G exhibited severe sizing shedding during twisting.

The yarns of Samples E-H and Comparative Sample were evaluated for Air Drag in a similar manner to Example 4 above, except that the Air Drag values were determined for two bobbin samples at the pressures indicated in Table 9. Each yarn was evaluated for average number of broken filaments per 1200 meters of yarn at 200 meters per minute using a Shirley Model No. 84 041 L broken filament detector, which is commercially available from SDL International Inc. of England. These values represent the average of measurements conducted on four bobbins of each yarn. The broken filament values are reported from sections taken from a full bobbin, 136 grams (3/10 pound) and 272 grams (6/10 pound) of yarn unwound from the bobbin.

Each yarn was also evaluated for Gate Tension testing are set forth in Table 9 below. The number of broken filaments measured according to the Gate Tension Method is determined by unwinding a sample of yarn from a bobbin at 200 meters/minute, threading the yarn through a series of 8 parallel ceramic pins and passing the yarn through the Shirley broken filament detector discussed above to count the number of broken filaments.

**TABLE 9**

| NUMBER OF BROKEN FILAMENTS PER METER OF YARN | | Sample E | Sample F | Sample G | Sample H | Comp. Sample |
|---|---|---|---|---|---|---|
| full bobbin | | 0.887 | 0.241 | greater than 10 | 0.065 | 0.192 |
| 136 grams (3/10 pound) | | 0.856 | 0.017 | greater than 10 | 0.013 | 0.320 |
| 272 grams (6/10 pound) | | 0.676 | 0.030 | greater than 10 | 0.101 | 0.192 |

| GATE TENSION (number of hairs per meter) | | | | | | |
|---|---|---|---|---|---|---|
| Gate 2 | | - | 0.039 | - | 0.0235 | 0.721 |
| Gate 3 | | - | 0.025 | - | 0.028 | 0.571 |
| Gate 4 | | - | 0.0125 | - | 0.068 | 0.4795 |
| Gate 5 | | - | 0.015 | - | 0.093 | 0.85 |
| Gate 6 | | - | 0.0265 | - | 0.118 | 0.993 |
| Gate 7 | | - | 0.0695 | - | 0.31 | 1.0835 |
| Gate 8 | | - | 0.117 | - | 0.557 | 1.81 |

| AIR DRAG (grams) | | | | | | |
|---|---|---|---|---|---|---|
| 25 psi | Bobbin 1 | - | 10.420 | - | 10.860 | 11.610 |
| | Bobbin 2 | - | 10.600 | - | 7.850 | 11.610 |
| 30 psi | Bobbin 1 | - | 11.690 | - | 12.500 | 13.680 |
| | Bobbin 2 | - | 12.200 | - | 8.540 | 13.850 |
| 35 psi | Bobbin 1 | - | 13.490 | - | 14.030 | 15.880 |
| | Bobbin 2 | - | 13.530 | - | 9.570 | 15.630 |
| 40 psi | Bobbin 1 | - | 14.740 | - | 14.110 | 17.560 |
| | Bobbin 2 | - | 14.860 | - | 11.010 | 17.610 |
| 45 psi | Bobbin 1 | - | 16.180 | - | 16.390 | 19.830 |
| | Bobbin 2 | - | 16.680 | - | 12.700 | 18.950 |
| 50 psi | Bobbin 1 | - | 17.510 | - | 19.280 | 22.410 |
| | Bobbin 2 | - | 17.730 | - | 14.000 | 20.310 |
| 55 psi | Bobbin 1 | - | 19.570 | - | 23.350 | 29.350 |
| | Bobbin 2 | - | 19.660 | - | 20.250 | 26.580 |

While the test results presented in Table 9 appear to indicate that Samples E-H according to the present invention had generally higher abrasion resistance than the Comparative Sample, it is believed that these results are not conclusive since it is believed that a polyethylene emulsion component of the Comparative Sample, which was not present in Samples EH, contributed to abrasive properties of the yarn.

### EXAMPLE 6

Five layers of ADFLO-C™ needled chopped glass fiber mat, which is commercially available from PPG Industries, Inc., were stacked to form a mat having a surface weight of about 4614 grams per square meter (15 ounces per square foot). The thickness of each sample was about 25 millimeters (about 1 inch). Four eight-inch square samples of this mat were heated to a temperature of about 649°C (about 1200°F) to remove essentially all of the sizing components from the samples.

Two uncoated samples were used as comparative samples. The other two samples were dipped and saturated in a bath of an aqueous coating composition consisting of 1150 milliliters of ORPAC BORON NITRIDE RELEASECOAT-CONC (25 weight percent boron nitride particles in an aqueous dispersion) and 150 milliliters of a 5 weight percent aqueous solution of A-187 gamma-glycidoxypropyltrimethoxysilane. The total solids of the aqueous coating composition was about 18.5 weight percent. The amount of boron nitride particles applied to each mat sample was about 120 grams. The coated mat samples were dried in air overnight at a temperature of about 25°C and heated in an oven at about 150°C for about three hours.

Each set of samples was evaluated for thermal conductivity and thermal resistance in air at temperatures of about 300K (about 70°F) according to ASTM Method C-177, which is hereby incorporated by reference. The values for thermal conductivity and thermal resistance for each sample are set forth in Table 10 below.

**Table 10**

| | **Sample** | |
|---|---|---|
| | **X** | **Comp. Sample** |
| **Thickness** (inches) | 1.09 | 1.0 |
| (centimeters) | 2.77 | 2.54 |
| **Temperature** (°F) | 75.62 | 74.14 |
| (°C) | 24.23 | 23.41 |
| **Thermal conductivity** | | |
| Btu inches per hour square feet°F | 0.373 | 0.282 |
| Watts per meter K | 0.054 | 0.041 |
| **Thermal resistance** | | |
| Hour square feet °F per BTU | 2.92 | 3.55 |
| meter² K per Watts | 0.515 | 0.626 |

Referring to Table 10, the thermal conductivity at a temperature about 300K of the test sample coated with boron nitride particles according to the present invention was greater than the thermal conductivity of the Comparative Sample which was not coated with boron nitride particles.

### EXAMPLE 7

Filament wound cylindrical composites were prepared from samples of G-75 yarn coated with sizing G of Example 5 above and 1062 glass fiber yarn which is commercially available from PPG Industries, Inc. The cylinders were prepared by drawing eight ends of yarn from a yarn supply, coating the yarn with the matrix materials set forth below, and filament winding the yarn into a cylindrical shape using a conventional filament winding apparatus. Each of the cylinders was 12.7 centimeters (5 inches) high, had an internal diameter of 14.6 centimeters (5.75 inches) and a wall thickness of 0.635 centimeters (0.25 inches).

The matrix materials were a mixture of 100 parts EPON 880 epoxy resin (commercially available from Shell Chemical), 80 parts AC-220J methyl tetrahydro phthalic anhydride (commercially available from Anhydrides and Chemicals, Inc. of Newark, New Jersey), and 1 part ARALDITE® DY 062 benzyl dimethyl amine accelerator (commercially available from Ciba-Geigy). The filament wound cylinders were cured for two hours at 100°C and then for three hours at 150°C.

The radial thermal diffusivity (thermal conductivity/(heat capacity x density)) of each test sample in air was determined by exposing one side of the cylinder wall of the sample to a 6.4 kJ flash lamp and sensing the temperature change on the opposite side of the wall using a CCD array infrared camera at a rate of up to 2000 frames per second. Thermal diffusivity values were also determined along a length of the yarn (circumferential) and along a length or height of the cylinder (axial). The test results are set forth below in Table 11.

**Table 11**

| | **Thermal Diffusivity (mm**^{**2**}**/sec)** | | |
|---|---|---|---|
| | **radial** | **axial** | **circumferential** |
| Sample | 0.37 | 0.33 | 0.49 |
| Comparative Sample | 0.38 | 0.38 | 0.57 |

Referring to Table 11, the values of thermal diffusivity for the test sample (which was coated with a small amount of boron nitride) are less than those of the comparative sample, which was not coated with boron nitride. Air voids in the filament wound cylinder and the small sample area tested are factors which may have influenced these results.

From the foregoing description, it can be seen that the present invention provides glass fiber strands having an abrasion-resistant coating which provide good thermal stability, low corrosion and reactivity in the presence of high humidity, reactive acids and alkalies and compatibility with a variety of polymeric matrix materials. These strands can be twisted or chopped, formed into a roving, chopped mat or continuous strand mat or woven or knitted into a fabric for use in a wide variety of applications, such as reinforcements for composites such as printed circuit boards.

It will be appreciated by those skilled in the art that changes could be made to the embodiments described above without departing from the broad inventive concept thereof. It is understood, therefore, that this invention is not limited to the particular embodiments disclosed, but it is intended to cover modifications which are within the spirit and scope of the invention, as defined by the appended claims.

## Claims

1. A coated fiber strand comprising a plurality of glass fibers having an average nominal fiber diameter greater than 5 micrometers, the strand being at least partially impregnated with a dried residue of a first aqueous sizing or coating composition comprising solid particles which provide interstitial spaces between adjacent glass fibers of the strand, the solid particles having a minimum average particle size of at least 3 micrometers and a hardness which does not exceed a hardness of the plurality of glass fibers.

2. The coated fiber strand according to claim 1, wherein the strand being at least partially impregnated with (1) a primary layer of a dried residue of a second sizing composition applied to at least a portion of surfaces of the plurality of glass fibers and (2) a secondary layer of the first aqueous coating composition applied over at least a portion of the primary layer.

3. The coated fiber strand according to claim 2, wherein the solid particles of the first aqueous coating composition are hydrophilic solid particles which upon exposure to water absorb and retain water in interstices within the hydrophilic solid particles.

4. A coated fiber strand comprising a plurality of glass fibers having an average nominal fiber diameter greater than 5 micrometers, the strand being at least partially impregnated with (1) a primary layer of a dried residue of a second sizing composition applied to at least a portion of surfaces of the plurality of glass fibers; (2) a secondary layer of a third coating composition applied over at least a portion of the primary layer, the third coating composition comprising a polymeric material; and (3) a tertiary layer comprising powdered solid particles applied over at least a portion of the secondary layer which provide interstitial spaces between adjacent glass fibers of the strand, the solid particles having a minimum average particle size of at least 3 micrometers.

5. The coated fiber strand according to any of claims 1 to 4, wherein the at least one glass fiber is selected from the group consisting of E-glass fibers, D-glass fibers, S-glass fibers, Q-glass fibers, E-glass derivative fibers, and combinations thereof.

6. The coated fiber strand according to claim 5, wherein the at least one glass fiber is an E-glass fiber.

7. The coated fiber strand according to claim 5, wherein the at least one glass fiber is an E-glass derivative fibers.

8. The coated fiber strand according to any of claims 1 to 7, wherein the average nominal fiber diameter of the plurality of glass fibers is greater than 9 micrometers.

9. The coated fiber strand according to any of claims 1 to 8, wherein the minimum average particle size of the solid particles ranges from 3 micrometers to less than about 1000 micrometers.

10. The coated fiber strand according to any of claims 1 to 8, wherein the minimum average particle size of the solid particles is at least about 5 micrometers.

11. The coated fiber strand according to any of claims 1 to 4, wherein the hardness value of the solid particles is less than or equal to the hardness value of the glass fibers.

12. The coated fiber strand according to any of claims 1 to 4, wherein the solid particles have a Mohs' hardness value ranging from 1 to 6.

13. The coated fiber strand according to any of claims 1 to 4, wherein each of the solid particles has a shape independently selected from the group consisting of spherical, cubic, platy and acicular.

14. The coated fiber strand according to any of claims 1 to 4, wherein the solid particles are formed from inorganic materials, organic materials and mixtures thereof.

15. The coated fiber strand according to claims 1, 2, or 4, wherein the solid particles are formed from at least one inorganic material selected from the group consisting of ceramic materials and metallic materials.

16. The coated fiber strand according to claim 15, wherein the solid particles are formed from at least one ceramic material selected from the group consisting of metal nitrides, metal oxides, metal carbides, metal sulfides, metal borides, metal silicates, metal carbonates and mixtures thereof.

17. The coated fiber strand according to claim 16, wherein the solid particles are formed from a metal nitride which is hexagonal crystal structure boron nitride.

18. The coated fiber strand according to claim 16, wherein the solid particles are formed from a metal oxide which is zinc oxide.

19. The coated fiber strand according to claim 16, wherein the solid particles are formed from at least one metal sulfide selected from the group consisting of molybdenum disulfide, tantalum disulfide, tungsten disulfide, zinc sulfide and mixtures thereof.

20. 15. The coated fiber strand according to claim 16, wherein the solid particles are formed from at least one metal silicate selected from the group consisting of aluminum silicates, magnesium silicates and mixtures thereof.

21. The coated fiber strand according to claim 16, wherein the solid particles are formed from at least one metallic material selected from the group consisting of graphite, molybdenum, platinum, palladium, nickel, aluminum, copper, gold, iron, silver and mixtures thereof.

22. The coated fiber strand according to claim 14, wherein the solid particles are formed from at least one organic polymeric material selected from the group consisting of thermosetting materials, thermoplastic materials, starches and mixtures thereof.

23. The coated fiber strand according to claim 22, wherein the solid particles are formed from at least one thermosetting material selected from the group consisting of thermosetting polyesters, vinyl esters, epoxy materials, phenolics, aminoplasts, thermosetting polyurethanes and mixtures thereof.

24. The coated fiber strand according to claim 22, wherein the solid particles are formed from at least one thermoplastic material selected from the group consisting of vinyl polymers, thermoplastic polyesters, polyolefins, polyamides, thermoplastic polyurethanes, acrylic polymers and mixtures thereof.

25. The coated fiber strand according to any of claims 1 to 3 wherein the first aqueous sizing or coating composition is essentially free of hydratable inorganic solid particles.

26. The coated fiber strand according to any of claims 1 to 3, wherein the solid particles comprise greater than 20 to 99 weight percent of the first sizing or coating composition on a total solids basis.

27. The coated fiber strand according to claim 26, wherein the solid particles comprise at least 25 weight percent of the first sizing or coating composition on a total solids basis.

28. The coated fiber strand according to claim 27, wherein the solid particles comprise greater than 50 weight percent of the sizing composition on a total solids basis.

29. The coated fiber strand according to any of claims 1 to 3, wherein the sizing composition further comprises at least one polymeric film-forming material selected from the group consisting of thermosetting materials, thermoplastic materials, starches and mixtures thereof.

30. The coated fiber strand according to any of claims 1 to 3, wherein the first sizing or coating composition further comprises a glass fiber coupling agent.

31. The coated fiber strand according to any of claims 1 to 4, wherein at lest one of the one least one glass fiber is formed from a fiberizable material selected from the group consisting of non-glass inorganic materials, natural materials, organic polymeric materials and combinations thereof.

32. A reinforced polymeric composite comprising:
(a) a coated fiber strand according to any of claims 1 to 3 or 10, and
(b) a polymeric matrix material.

33. A fabric comprising a coated fiber strand according to any of claims 1 to 3 or 10.

34. An electronic support comprising:
(a) a fabric according to claim 33, and
(b) a layer of a polymeric matrix material applied over at least a portion of the fabric forming a first composite layer.

35. The electronic support of claim 34, wherein the support comprising further a second composite layer different from the first composite layer.

36. The electronic support according to claims 34 or 35, wherein the support is a first, second or third level package.

37. An electronic circuit board comprising:
(a) an electronic support according to any of claims 34 to 36, and
(b) an electrically conductive layer positioned adjacent to selected portions of selected sides of said electronic support.

38. The electronic circuit board according to claim 37, further comprising at least one aperture extending through at least a portion of the circuit board.

## Patentansprüche

1. Beschichteter Faserstrang, enthaltend eine Vielzahl von Glasfasern mit einem mittleren Nenndurchmesser der Fasern von größer als 5 µm, wobei der Strang mindestens teilweise imprägniert ist mit einem getrockneten Rückstand einer ersten wässrigen Schlicht- oder Beschichtungszusammensetzung, die feste Teilchen enthält, um Zwischenräume zwischen benachbarten Glasfasern des Stranges zu schaffen, wobei die festen Teilchen eine minimale mittlere Teilchengröße von mindestens 3 µm aufweisen und eine Härte haben, die die Härte der Vielzahl von Glasfasern nicht überschreitet.

2. Beschichteter Faserstrang nach Anspruch 1, **dadurch gekennzeichnet, dass** der Strang mindestens teilweise imprägniert ist mit (1) einer ersten Schicht eines getrockneten Rückstandes einer zweiten Schlichtzusammensetzung, aufgebracht auf mindestens einen Teil von Oberflächen der Vielzahl von Glasfasern, und (2) einer zweiten Schicht der ersten wässrigen Beschichtungszusammensetzung, aufgebracht auf mindestens einen Teil der ersten Schicht.

3. Beschichteter Faserstrang nach Anspruch 2, **dadurch gekennzeichnet, dass** die festen Teilchen der ersten wässrigen Beschichtungszusammensetzung hydrophile feste Teilchen sind, die Wasser ausgesetzt, Wasser absorbieren und in Zwischenräumen zwischen den hydrophilen festen Teilchen zurückhalten.

4. Beschichteter Faserstrang, enthaltend eine Vielzahl von Glasfasern mit einem mittleren Nenndurchmesser der Fasern von größer als 5 µm, wobei der Strang mindestens teilweise imprägniert ist mit (1) einer ersten Schicht eines getrockneten Rückstandes einer zweiten Schlichtzusammensetzung, aufgebracht auf mindestens einen Teil von Oberflächen der Vielzahl von Glasfasern, (2) einer zweiten Schicht einer dritten Beschichtungszusammensetzung, aufgebracht auf mindestens einen Teil der ersten Schicht, wobei die dritte Beschichtungszusammensetzung ein polymeres Material enthält, und (3) einer dritten Schicht, enthaltend pulverförmige feste Teilchen, aufgebracht auf mindestens einen Teil der zweiten Schicht, die Zwischenräume zwischen benachbarten Glasfasern des Stranges schaffen, wobei die festen Teilchen eine minimale mittlere Teilchengröße von mindestens 3 µm aufweisen.

5. Beschichteter Faserstrang nach einem der Ansprüche 1 bis 4, **dadurch gekennzeichnet, dass** die mindestens eine Glasfaser aus der aus E-Glasfasern, D-Glasfasern, S-Glasfasern, Q-Glasfasern, E-Glasderivatfasern und Kombinationen derselben bestehenden Gruppe ausgewählt ist.

6. Beschichteter Faserstrang nach Anspruch 5, **dadurch gekennzeichnet, dass** die mindestens eine Glasfaser eine E-Glasfaser ist.

7. Beschichteter Faserstrang nach Anspruch 5, **dadurch gekennzeichnet, dass** die mindestens eine Glasfaser eine E-Glasderivatfaser ist.

8. Beschichteter Faserstrang nach einem der Ansprüche 1 bis 7, **dadurch gekennzeichnet, dass** der mittlere Nenndurchmesser der Fasern der Vielzahl von Glasfasern größer als 9 µm ist.

9. Beschichteter Faserstrang nach einem der Ansprüche 1 bis 8, **dadurch gekennzeichnet, dass** der minimale mittlere Teilchendurchmesser der festen Teilchen im Bereich von 3 µm bis weniger als etwa 1000 µm liegt.

10. Beschichteter Faserstrang nach einem der Ansprüche 1 bis 8, **dadurch gekennzeichnet, dass** der minimale mittlere Teilchendurchmesser der festen Teilchen mindestens etwa 5 µm beträgt.

11. Beschichteter Faserstrang nach einem der Ansprüche 1 bis 4, **dadurch gekennzeichnet, dass** der Härtewert der festen Teilchen kleiner als oder gleich dem Härtewert der Glasfasern ist.

12. Beschichteter Faserstrang nach einem der Ansprüche 1 bis 4, **dadurch gekennzeichnet, dass** die festen Teilchen einen Mohs-Härtewert von 1 bis 6 aufweisen.

13. Beschichteter Faserstrang nach einem der Ansprüche 1 bis 4, **dadurch gekennzeichnet, dass** jedes der festen Teilchen eine Form aufweist, die unabhängig aus der aus sphärischen, kubischen, tafeligen und nadelförmigen Formen bestehenden Gruppe ausgewählt ist.

14. Beschichteter Faserstrang nach einem der Ansprüche 1 bis 4, **dadurch gekennzeichnet, dass** die festen Teilchen aus anorganischen Materialien, organischen Materialien und Mischungen derselben ausgebildet sind.

15. Beschichteter Faserstrang nach einem der Ansprüche 1, 2 oder 4, **dadurch gekennzeichnet, dass** die festen Teilchen aus mindestens einem anorganischen Material, ausgewählt aus der Gruppe bestehend aus keramischen Materialien und metallischen Materialien, ausgebildet sind.

16. Beschichteter Faserstrang nach Anspruch 15, **dadurch gekennzeichnet, dass** die festen Teilchen ausgebildet sind aus mindestens einem keramischen Material, ausgewählt aus der Gruppe bestehend aus Metallnitriden, Metalloxiden, Metallcarbiden, Metall Sulfiden, Metallboriden, Metallsilicaten, Metallcarbonaten und Mischungen derselben.

17. Beschichteter Faserstrang nach Anspruch 16, **dadurch gekennzeichnet, dass** die festen Teilchen aus einem Metallnitrid ausgebildet sind, das ein Bornitrid mit hexagonaler Kristallstruktur ist.

18. Beschichteter Faserstrang nach Anspruch 16, **dadurch gekennzeichnet, dass** die festen Teilchen aus einem Metalloxid ausgebildet sind, das Zinkoxid ist.

19. Beschichteter Faserstrang nach Anspruch 16, **dadurch gekennzeichnet, dass** die festen Teilchen ausgebildet sind aus mindestens einem Metallsulfid, ausgewählt aus der Gruppe bestehend aus Molybdändisulfid, Tantaldisulfid, Wolframdisulfid, Zinksulfid und Mischungen derselben.

20. Beschichteter Faserstrang nach Anspruch 16, **dadurch gekennzeichnet, dass** die festen Teilchen ausgebildet sind aus mindestens einem Metallsilicat, ausgewählt aus der Gruppe bestehend aus Aluminiumsilicaten, Magnesiumsilicaten und Mischungen derselben.

21. Beschichteter Faserstrang nach Anspruch 16, **dadurch gekennzeichnet, dass** die festen Teilchen ausgebildet sind aus mindestens einem metallischen Material, ausgewählt aus der Gruppe bestehend aus Graphit, Molybdän, Platin, Palladium, Nickel, Aluminium, Kupfer, Gold, Eisen, Silber und Mischungen derselben.

22. Beschichteter Faserstrang nach Anspruch 14, **dadurch gekennzeichnet, dass** die festen Teilchen ausgebildet sind aus mindestens einem organischen Polymermaterial, ausgewählt aus der Gruppe bestehend aus wärmehärtenden Materialien, thermoplastischen Materialien, Stärken und Mischungen derselben.

23. Beschichteter Faserstrang nach Anspruch 22, **dadurch gekennzeichnet, dass** die festen Teilchen ausgebildet sind aus mindestens einem wärmehärtenden Material, ausgewählt aus der Gruppe bestehend aus wärmehärtenden Polyestern, Vinylestern, Epoxymaterialien, phenolischen Materialien, Aminoplasten, wärmehärtenden Polyurethanen und Mischungen derselben.

24. Beschichteter Faserstrang nach Anspruch 22, **dadurch gekennzeichnet, dass** die festen Teilchen ausgebildet sind aus mindestens einem thermoplastischen Material, ausgewählt aus der Gruppe bestehend aus Vinylpolymeren, thermoplastischen Polyestern. Polyolefinen, Polyamiden, thermoplastischen Polyurethanen, Acrylpolymeren und Mischungen derselben.

25. Beschichteter Faserstrang nach einem der Ansprüche 1 bis 3, **dadurch gekennzeichnet, dass** die erste wässrige Schlicht- oder Beschichtungszusammensetzung im wesentlichen frei von wasseraufnehmenden anorganischen festen Teilchen ist.

26. Beschichteter Faserstrang nach einem der Ansprüche 1 bis 3, **dadurch gekennzeichnet, dass** die festen Teilchen mehr als 20 bis 99 Gew.-%, bezogen auf Gesamtfeststoffe der ersten Schlicht- oder Beschichtungszusammensetzung, ausmachen.

27. Beschichteter Faserstrang nach Anspruch 26, **dadurch gekennzeichnet, dass** die festen Teilchen mindestens 25 Gew.-%, bezogen auf Gesamtfeststoffe der ersten Schlicht- oder Beschichtungszusammensetzung, ausmachen.

28. Beschichteter Faserstrang nach Anspruch 27, **dadurch gekennzeichnet, dass** die festen Teilchen mehr als 50 Gew.-%, bezogen auf Gesamtfeststoffe der Schlichtzusammensetzung, ausmachen.

29. Beschichteter Faserstrang nach einem der Ansprüche 1 bis 3, **dadurch gekennzeichnet, dass** die Schlichtzusammensetzung weiterhin mindestens ein polymeres filmbildendes Material enthält, ausgewählt aus der Gruppe bestehend aus wärmehärtenden Materialien, thermoplastischen Materialien, Stärken und Mischungen derselben.

30. Beschichteter Faserstrang nach einem der Ansprüche 1 bis 3, **dadurch gekennzeichnet, dass** die erste Schlicht- oder Beschichtungszusammensetzung weiterhin ein Glasfaserkupplungsmittel enthält.

31. Beschichteter Faserstrang nach einem der Ansprüche 1 bis 4, **dadurch gekennzeichnet, dass** mindestens eine der mindestens einen Glasfaser ausgebildet ist aus einem zu Fasern verarbeitbarem Material, ausgewählt aus der Gruppe bestehend aus anorganischen Materialien, die nicht Glas sind, natürlichen Materialien, organischen polymeren Materialien und Kombinationen derselben.

32. Verstärkter Polymerverbundwerkstoff, enthaltend:
(a) einen beschichteten Faserstrang nach einem der Ansprüche 1 bis 3 oder 10 und
(b) ein polymeres Matrixmaterial.

33. Textilerzeugnis, enthaltend einen beschichteten Faserstrang nach einem der Ansprüche 1 bis 3 oder 10.

34. Elektronischer Träger enthaltend
(a) ein Textilerzeugnis nach Anspruch 33 und
(b) eine Schicht eines polymeren Matrixmaterials, aufgebracht auf mindestens einen Teil des Textilerzeugnisses, die eine erste Verbundmaterialschicht ausbildet.

35. Elektronischer Träger nach Anspruch 34, **dadurch gekennzeichnet, dass** der Träger weiterhin eine zweite Verbundmaterialschicht aufweist, die sich von der ersten Verbundmaterialschicht unterscheidet.

36. Elektronischer Träger nach Ansprüchen 34 oder 35, **dadurch gekennzeichnet, dass** der Träger eine Baugruppe der ersten, zweiten oder dritten Ebene ist.

37. Elektronische Leiterplatte enthaltend:
(a) einen elektronischen Träger nach einem der Ansprüche 34 bis 36 und
(b) eine elektrisch leitende Schicht angeordnet neben ausgewählten Teilen ausgewählter Seiten des elektronischen Trägers.

38. Elektronische Leiterplatte nach Anspruch 37, **dadurch gekennzeichnet, dass** sie weiterhin mindestens eine Öffnung aufweist, die sich durch mindestens einen Teil der Leiterplatte erstreckt.

## Revendications

1. Paquet de fibres enrobées comprenant une pluralité de fibres de verre ayant un diamètre de fibre nominal moyen plus grand que 5 micromètres, le paquet étant au moins partiellement imprégné d'un résidu séché d'une première composition d'apprêt ou d'enrobage aqueuse comprenant des particules solides qui forment des espaces interstitielles entre fibres de verre adjacentes du paquet, les particules solides ayant une taille de particule moyenne minimale d'au moins 3 micromètres et une dureté qui n'excède pas une dureté de la pluralité des fibres de verre.

2. Paquet de fibres enrobées suivant la revendication 1, dans lequel le paquet est au moins partiellement imprégné (1) d'une couche primaire d'un résidu séché d'une seconde composition d'apprêt appliquée sur au moins une partie de surfaces de la pluralité de fibres de verre et (2) d'une couche secondaire de la première composition d'enrobage aqueuse appliquée sur au moins une partie de la couche primaire.

3. Paquet de fibres enrobées suivant la revendication 2, dans lequel les particules solides de la première composition d'enrobage aqueuse sont des particules solides hydrophiles qui lors d'une exposition à l'eau absorbent et retiennent de l'eau dans des interstices dans les particules solides hydrophiles.

4. Paquet de fibres enrobées comprenant une pluralité de fibres de verre ayant un diamètre de fibre nominal moyen plus grand que 5 micromètres, le paquet étant au moins partiellement imprégné (1) d'une couche primaire d'un résidu séché d'une seconde composition d'apprêt appliquée sur au moins une partie de surfaces de la pluralité de fibres de verre, (2) d'une couche secondaire d'une troisième composition d'enrobage appliquée sur au moins une partie de la couche primaire, la troisième composition d'enrobage comprenant une matière polymérique, et (3) d'une couche tertiaire comprenant des particules solides pulvérulentes appliquées sur au moins une partie de la couche secondaire qui forment des espaces interstitiels entre fibres de verre adjacentes du paquet, les particules solides ayant une taille de particule moyenne minimale d'au moins 3 micromètres.

5. Paquet de fibres enrobées suivant l'une quelconque des revendications 1 à 4, dans lequel au moins la fibre de verre est choisie dans le groupe comprenant les fibres de verre E, les fibres de verre D, les fibres de verre S, les fibres de verre Q, les fibres de dérivés de verre E et leurs combinaisons.

6. Paquet de fibres enrobées suivant la revendication 5, dans lequel au moins la fibre de verre est une fibre de verre E.

7. Paquet de fibres enrobées suivant la revendication 5, dans lequel au moins la fibre de verre est une fibre de dérivé de verre E.

8. Paquet de fibres enrobées suivant l'une quelconque des revendications 1 à 7, dans lequel le diamètre de fibre nominal moyen de la pluralité de fibres de verre est plus grand que 9 micromètres.

9. Paquet de fibres enrobées suivant l'une quelconque des revendications 1 à 8, dans lequel la taille de particule moyenne minimale des particules solides va de 3 micromètres à moins d'environ 1.000 micromètres.

10. Paquet de fibres enrobées suivant l'une quelconque des revendications 1 à 8, dans lequel la taille de particule moyenne minimale des particules solides est d'au moins environ 5 micromètres.

11. Paquet de fibres enrobées suivant l'une quelconque des revendications 1 à 4, dans lequel l'indice de dureté des particules solides est inférieur ou égal à l'indice de dureté des fibres de verre.

12. Paquet de fibres enrobées suivant l'une quelconque des revendications 1 à 4, dans lequel les particules solides ont une dureté de Mohs allant de 1 à 6.

13. Paquet de fibres enrobées suivant l'une quelconque des revendications 1 à 4, dans lequel chacune des particules solides a une forme indépendamment choisie dans le groupe comprenant les formes sphérique, cubique, tabulaire et aciculaire.

14. Paquet de fibres enrobées suivant l'une quelconque des revendications 1 à 4, dans lequel les particules solides sont formées de matières inorganiques, de matières organiques et de leurs mélanges.

15. Paquet de fibres enrobées suivant l'une quelconque des revendications 1, 2 et 4, dans lequel les particules solides sont formées d'au moins une matière inorganique choisie dans le groupe comprenant les matières céramiques et les matières métalliques.

16. Paquet de fibres enrobées suivant la revendication 15, dans lequel les particules solides sont formées d'au moins une matière céramique choisie dans le groupe comprenant les nitrures métalliques, les oxydes métalliques, les carbures métalliques, les sulfures métalliques, les borures métalliques, les silicates métalliques, les carbonates métalliques et leurs mélanges.

17. Paquet de fibres enrobées suivant la revendication 16, dans lequel les particules solides sont formées d'un nitrure métallique qui est du nitrure de bore d'une structure de cristal hexagonal.

18. Paquet de fibres enrobées suivant la revendication 16, dans lequel les particules solides sont formées d'un oxyde métallique qui est de l'oxyde de zinc.

19. Paquet de fibres enrobées suivant la revendication 16, dans lequel les particules solides sont formées d'au moins un sulfure métallique choisi dans le groupe comprenant le disulfure de molybdène, le disulfure de tantale, le disulfure de tungstène, le sulfure de zinc et leurs mélanges.

20. Paquet de fibres enrobées suivant la revendication 16, dans lequel les particules solides sont formées d'au moins un silicate métallique choisi dans le groupe comprenant les silicates d'aluminium, les silicates de magnésium et leurs mélanges.

21. Paquet de fibres enrobées suivant la revendication 16, dans lequel les particules solides sont formées d'au moins une matière métallique choisie dans le groupe comprenant le graphite, le molybdène, le platine, le palladium, le nickel, l'aluminium, le cuivre, l'or, le fer, l'argent et leurs mélanges.

22. Paquet de fibres enrobées suivant la revendication 14, dans lequel les particules solides sont formées d'au moins une matière polymérique organique choisie dans le groupe comprenant les matières thermodurcissables, les matières thermoplastiques, les amidons et leurs mélanges.

23. Paquet de fibres enrobées suivant la revendication 22, dans lequel les particules solides sont formées d'au moins une matière thermodurcissable choisie dans le groupe comprenant les polyesters thermodurcissables, les esters vinyliques, les matières époxy, les composés phénoliques, les aminoplastes, les polyuréthannes thermodurcissables et leurs mélanges.

24. Paquet de fibres enrobées suivant la revendication 22, dans lequel les particules solides sont formées d'au moins une matière thermoplastique choisie dans le groupe comprenant les polymères vinyliques, les polyesters thermoplastiques, les polyoléfines, les polyamides, les polyuréthannes thermoplastiques, les polymères acryliques et leurs mélanges.

25. Paquet de fibres enrobées suivant l'une quelconque des revendications 1 à 3, dans lequel la première composition d'apprêt ou d'enrobage aqueuse est essentiellement exempte de particules solides inorganiques hydratables.

26. Paquet de fibres enrobées suivant l'une quelconque des revendications 1 à 3, dans lequel les particules solides comprennent plus de 20 à 99 % en poids de la première composition d'apprêt ou d'enrobage sur la base des matières solides totales.

27. Paquet de fibres enrobées suivant la revendication 26, dans lequel les particules solides comprennent au moins 25 % en poids de la première composition d'apprêt ou d'enrobage sur la base des matières solides totales.

28. Paquet de fibres enrobées suivant la revendication 27, dans lequel les particules solides comprennent plus de 50 % en poids de la composition d'apprêt sur la base de matières solides totales.

29. Paquet de fibres enrobées suivant l'une quelconque des revendications 1 à 3, dans lequel la composition d'apprêt comprend de plus au moins une matière filmogène polymérique choisie dans le groupe comprenant les matières thermodurcissables, les matières thermoplastiques, les amidons et leurs mélanges.

30. Paquet de fibres enrobées suivant l'une quelconque des revendications 1 à 3, dans lequel la première composition d'apprêt ou d'enrobage comprend de plus un agent de couplage de fibres de verre.

31. Paquet de fibres enrobées suivant l'une quelconque des revendications 1 à 4, dans lequel au moins une d'au moins la fibre de verre est formée d'une matière pouvant être amenée à l'état de fibres choisie dans le groupe comprenant les matières inorganiques non vitreuses, les matières naturelles, les matières polymériques organiques et leurs combinaisons.

32. Composite polymérique renforcé comprenant :
(a) un paquet de fibres enrobées suivant l'une quelconque des revendications 1 à 3 et 10, et
(b) une matière matricielle polymérique.

33. Tissu comprenant un paquet de fibres enrobées suivant l'une quelconque des revendications 1 à 3 et 10.

34. Support électronique comprenant :
(a) un tissu suivant la revendication 33, et
(b) une couche d'une matière matricielle polymérique appliquée sur au moins une partie du tissu formant une première couche composite.

35. Support électronique suivant la revendication 34, dans lequel le support comprend de plus une seconde couche composite différente de la première couche composite.

36. Support électronique suivant l'une ou l'autre des revendications 34 et 35, dans lequel le support est un boîtier de premier, second ou troisième niveau.

37. Carte à circuit électronique comprenant :
(a) un support électronique suivant l'une quelconque des revendications 34 à 36, et
(b) une couche électriquement conductrice positionnée de façon adjacente à des parties choisies de faces choisies du support électronique.

38. Carte à circuit électronique suivant la revendication 37, comprenant de plus au moins une fenêtre s'étendant à travers au moins une partie de la carte à circuit.
